(19) Europäisches Patentamt
European Patent Office
Office européen des brevets

(11) EP 1 193 050 B1

(12) EUROPÄISCHE PATENTSCHRIFT

(45) Veröffentlichungstag und Bekanntmachung des Hinweises auf die Patenterteilung:
**30.05.2007 Patentblatt 2007/22**

(51) Int Cl.:
***B32B 27/18*** *(2006.01)* ***C08J 5/18*** *(2006.01)*
***C08K 5/13*** *(2006.01)* ***C08K 5/35*** *(2006.01)*

(21) Anmeldenummer: **01108497.7**

(22) Anmeldetag: **04.04.2001**

(54) **Hydrolysebeständig ausgerüstete, transparente, biaxial orientierte Folie aus einem kristallisierbaren Thermoplasten und Verfahren zu ihrer Herstellung**

Hydrolysis resistant, transparent, biaxially oriented film made from a crystallizable thermoplastic, and method for its preparation

Feuille transparente et biaxialement orientée, constituée de thermoplastes cristallisables et résistante à l'hydrolyse, et son procédé de production

(84) Benannte Vertragsstaaten:
**DE FR GB IT LU NL**

(30) Priorität: **29.09.2000 DE 10048720**
**29.09.2000 DE 10048721**

(43) Veröffentlichungstag der Anmeldung:
**03.04.2002 Patentblatt 2002/14**

(73) Patentinhaber: **Mitsubishi Polyester Film GmbH
65203 Wiesbaden (DE)**

(72) Erfinder:
- **Murschall, Ursula Dr.
55283 Nierstein (DE)**
- **Kern, Ulrich Dr.
55218 Ingelheim (DE)**
- **Kiehne, Thorsten Dr.
65185 Wiesbaden (DE)**
- **Hessberger, Harald Dr.
65529 Waldems (DE)**

(74) Vertreter: **Plate, Jürgen et al
Zounek Plate Schweitzer
Patentanwaltskanzlei
Rheingaustrasse 196
65203 Wiesbaden (DE)**

(56) Entgegenhaltungen:
**EP-A- 0 803 538**
**DE-A- 4 129 980**
**DE-A- 19 630 599**
**US-A- 5 804 626**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft eine ein- oder mehrschichtige, transparente, biaxial orientierte und thermofixierte Folie, die als Hauptbestandteil mindestens einen kristallisierbaren Thermoplasten enthält. Sie betrifft ferner ein Verfahren zur Herstellung der Folie und ihre Verwendung.

Transparente, biaxial orientierte Folien aus kristallisierbaren Thermoplasten, insbesondere aus kristallisierbaren Polyestern, sind bekannt und zahlreich beschrieben.

So ist in der US-A 4 399 179 ein Polyesterfolien-Laminat mit einer biaxial verstreckten, transparenten Basisschicht und mindestens einer wenigstens monoaxial verstreckten, mattierten Deckschicht offenbart, wobei die matte Schicht im wesentlichen aus einem Polyethylenterephthalat-Copolymer mit Einheiten aus Oligo- oder Polyethylenglykol und inerten Partikeln besteht. Die Partikel (bevorzugt aus Kieselsäure, Kaolin, Talkum, Zinkoxid, Aluminiumoxid, Calciumcarbonat oder Bariumsulfat) haben meist einen Durchmesser von 0,3 bis 20 µm. Ihr Anteil in der Deckschicht beträgt allgemein 3 bis 40 Gew.-% Basis- und/oder Deckschicht können darüber hinaus Antioxidantien, UV-Absorber, Pigmente oder Farbstoffe enthalten. Die durch die Partikel aufgerauhte Oberfläche der Deckschicht ist beschreibbar.

Die mehrschichtige, biaxial orientierte und thermofixierte Polyesterfolie gemäß der GB-A 1 465 973 umfaßt eine Schicht aus transparentem Polyethylenterephthalat und eine Schicht aus einem ebenfalls transparenten Copolyester. Der Oberfläche der Copolyesterschicht kann mit Hilfe von Walzen eine rauhe Struktur aufgeprägt werden, so daß die Folie beschreibbar wird.

In der EP-A 035 835 ist eine biaxial verstreckte und thermofixierte, mehrschichtige Polyesterfolie beschrieben, die eine Schicht aus einem hochkristallinen Polyester und damit verbunden eine siegelfähige Schicht aus einem im wesentlichen amorphen, linearen Polyester umfaßt. Die letztgenannte Schicht enthält feinverteilt Partikel, wobei der mittlere Durchmesser der Partikel größer ist als die Schichtdicke. Durch diese Partikel werden Oberflächenvorsprünge gebildet, die das unerwünschte Blocken und Kleben an Walzen oder Führungen verhindern. Die Folie läßt sich dadurch besser aufwickeln und verarbeiten. Durch die Wahl von Partikeln mit größerem Durchmesser als die Siegelschicht und den in den Beispielen angegebenen Konzentrationen wird das Siegelverhalten der Folie verschlechtert. Die Siegelnahtfestigkeit der gesiegelten Folie bei 140 °C liegt in einem Bereich von 63 bis 120 N/m (0,97 N/15 mm bis 1,8 N/15 mm Folienbreite).

In der EP-A 432 886 ist eine coextrudierte Folie mit einer Polyester-Basisschicht, einer Deckschicht aus einem siegelfähigen Polyester und einer rückseitigen Polyacrylatbeschichtung beschrieben. Die siegelfähige Deckschicht kann aus einem Copolyester mit Einheiten aus Isophthalsäure und Terephthalsäure bestehen. Durch die rückseitige Beschichtung erhält die Folie ein verbessertes Verarbeitungsverhalten. Die Siegelnahtfestigkeit wird bei 140 °C gemessen. Für eine 11 µm dicke Siegelschicht wird eine Siegelnahtfestigkeit von 761,5 N/m (11,4 N/15 mm) angegeben. Nachteilig an der rückseitigen Acrylatbeschichtung ist, daß diese Seite gegen die siegelfähige Deckschicht nicht mehr siegelt. Die Folie ist damit nur sehr eingeschränkt zu verwenden.

Eine coextrudierte, mehrschichtige, siegelfähige Polyesterfolie ist ferner in der EP-A 515 096 beschrieben. Die siegelfähigen Schicht enthält zusätzlich Pigmentierungspartikel, bevorzugt Kieselgelpartikel. Die Partikel können auch auf die bereits extrudierte Folie aufgebracht werden, beispielsweise durch Beschichten mit einer wäßrigen Kieselgel-Dispersion. Hierdurch soll die Folie die guten Siegeleigenschaften beibehalten und gut zu verarbeiten sein. Die Rückseite enthält nur sehr wenige Partikel, die hauptsächlich über das Regranulat in diese Schicht gelangen. Die Siegelnahtfestigkeit wird bei 140 °C gemessen und beträgt mehr als 200 N/m (3 N/15 mm). Für eine 3 µm dicke Siegelschicht wird eine Siegelnahtfestigkeit von 275 N/m (4,125 N/15 mm) angegeben.

Die aus der WO 98/06575 bekannte coextrudierte, mehrschichtige Polyesterfolie umfaßt eine siegelfähige Deckschicht und eine nicht siegelfähige Basisschicht. Die Basisschicht kann dabei aus einer oder mehreren Schichten aufgebaut sein, wobei die innere Schicht mit der siegelfähigen Schicht in Kontakt ist. Die andere (äußere) Schicht bildet dann die zweite, nicht siegelfähige Deckschicht. Die siegelfähige Deckschicht kann auch hier aus Copolyestern mit Einheiten aus Isophthalsäure und Terephthalsäure bestehen. Die Deckschicht enthält jedoch keine Antiblockpartikel. Die Folie enthält außerdem noch mindestens einen UV-Absorber, der in der Basisschicht in einem Anteil von 0,1 bis 10 Gew.-% enthalten ist. Als UV-Absorber werden dabei Zinkoxid- oder Titandioxid-Partikel mit einem mittleren Durchmesser von weniger als 200 nm, vorzugsweise jedoch Triazine, z.B. ®Tinuvin 1577 der Fa. Ciba, verwendet. Die Basisschicht ist mit üblichen Antiblockmitteln ausgestattet. Die Folie zeichnet sich durch eine gute Siegelfähigkeit aus, hat jedoch nicht das gewünschte Verarbeitungsverhalten und weist zudem Defizite in den optischen Eigenschaften auf.

Schichten aus Copolyester lassen sich auch durch Auftragen einer entsprechenden wäßrigen Dispersion erzeugen. So ist in der EP-A 144 978 eine Polyesterfolie beschrieben, die auf wenigstens einer Seite eine durchgehende Beschichtung aus dem Copolyester trägt. Die Dispersion wird auf die Folie vor dem Verstrecken bzw. vor dem letzten Verstreckschritt aufgebracht. Die Polyesterbeschichtung besteht aus einem Kondensationsprodukt von verschiedenen Monomeren, die zur Bildung von Polyestern befähigt sind, wie Isophthalsäure, aliphatische Dicarbonsäuren, Sulfomonomere und aliphatische oder cycloaliphatische Glykole.

In der DE-A 23 46 787 sind unter anderem schwer entflammbare Folien aus linearen Polyestern, die mit

Carboxyphosphinsäuren modifiziert sind, offenbart. Die Herstellung dieser Folien ist jedoch mit einer Reihe von Problemen verbunden. So ist der Rohstoff sehr hydrolyseempfindlich und muß sehr gut vorgetrocknet werden. Folie verspröden zudem bei zudem bei Temperaturbelastung. Die mechanischen Eigenschaften gehen dabei so stark zurück, daß die Folie unbrauchbar wird. Bereits nach 48 h Temperaturbelastung tritt diese Versprödung auf.

Die Folien aus dem Stand der Technik sind allgemein nicht ausreichend beständig gegen die Einwirkung von wäßrigen Medien, so daß sie bzw. die daraus hergestellten Artikel sich nicht für Anwendungen eignen, bei denen sie mit Feuchtigkeit oder Wasser in Berührung kommen. Auch in diesem Fall verschlechtern sich die mechanischen Eigenschaften, so daß die Folien dadurch völlig unbrauchbar werden können.

In der DE-A 196 30 599 ist eine ein- oder mehrschichtige, amorphe Polyethylenterephthalat-Platte mit einer Dicke von 0,8 bis 20 mm offenbart.

Gegenstand der DE-A 41 29 980 ist eine thermoplastische Formmassen auf der Basis von Polyester-Elastomeren und Oxazolinen. Bei den Polyester-Elastomeren handelt es sich um spezielle Copolyetherester.

In der EP-A 0 803 538 ist ein Hydrolysestabilisator für ein Estergruppen enthaltendes Harz offenbart, der als Hauptkomponente ein Carbodiimid mindestens zwei Carbodiimidgruppen enthält. Als Harze werden Polyesterpolyurethan, Polyethylenterephthalat und Polybutylenterephthalat genannt. Biaxial orientierte Folie sind nicht erwähnt.

In der US-A 5 808 626 ist eine Polyesterzusammensetzung aus Polyestern oder Copolyestern, die auf Naphthalin-2,6-dicarbonsäure basieren, und polymeren Carbodiimide beschrieben, die eine erhöhte Hydrolysebeständigkeit aufweist.

Es bestand daher die Aufgabe, eine transparente, biaxial orientierte und thermofixierte Folie bereitzustellen, die gute mechanische und optische Eigenschaften aufweist, einen niedrigen Schrumpf hat, keine Versprödung nach Temperaturbelastung zeigt, wirtschaftlich herstellbar und möglichst beständig gegen Wasser oder Feuchtigkeit ist.

Gefunden wurde nunmehr, daß sich diese Aufgabe durch Einarbeiten mindestens eines Hydrolysestabilisators lösen läßt. Einbußen bei den optischen und mechanischen Eigenschaften der Folie treten überraschenderweise nicht auf.

Gegenstand der vorliegenden Erfindung ist demnach eine ein- oder mehrschichtige, transparente, biaxial orientierte Folie, die als Hauptbestandteil mindestens einen kristallisierbaren Thermoplasten enthält und dadurch gekennzeichnet ist, daß sie mindestens einen Hydrolysestabilisator enthält.

Als Hydrolysestabilisatoren wirksam sind zum einen Verbindungen, die die Hydrolyse von Esterbindungen unterdrücken oder verlangsamen. Das sind beispielsweise phenolische Stabilisatoren. Dazu gehören sterisch gehinderte Phenole, Thio-bisphenole, Alkyliden-bisphenole, Alkylphenole, Hydroxybenzylverbindungen, Acyl-amino-phenole und Hydroxyphenylpropionate (insbesondere (3,5-Di-*tert*.-butyl-4-hydroxy-phenyl)-propionsäureester des Pentaerythrits oder des 1-Octadecanols, erhältlich unter der Bezeichnung ®Irganox von Ciba Specialty Chemicals). Diese Verbindungen sind beispielsweise beschrieben in der Monographie "Kunststoff additive" von Gächter und Müller, 2. Aufl., Carl Hanser Verlag. Der Anteil der phenolischen Stabilisatoren beträgt allgemein 0,1 bis 8,0 Gew.-%, bevorzugt 0,2 bis 5,0 Gew.-%, jeweils bezogen auf das Gewicht der Folie bzw. der damit ausgerüsteten Schicht (im Fall der mehrschichtigen Folie).

Die genannten phenolischen Stabilisatoren werden vorzugsweise kombiniert mit organischen Phosphiten, insbesondere mit Triarylphosphiten (erhältlich beispielsweise unter der Bezeichnung ®Irgafos 168 von Ciba Specialty Chemicals). Diese sind in der Lage, Peroxide abzubauen und wirken damit als Sekundärstabilisatoren. Das Gewichtsverhältnis von phenolischen Stabilisatoren zu organischen Phosphiten beträgt dabei allgemein 10 : 90 bis 90 : 10. Mischungen von primären und sekundären Hydrolysestabilisatoren sind ebenfalls kommerziell erhältlich, beispielsweise unter den Bezeichnungen ®irganox B 561 oder ®Irganox B 225.

Als Hydrolysestabilisatoren wirksam sind zum anderen Verbindungen, die bereits durch Hydrolyse gebrochene Bindungen wiederherstellen können. Um aus einer Hydroxy- und einer Carboxygruppe wieder eine Esterbindung herzustellen, eignen sich unter anderen monomere oder polymere Carbodiimide (speziell Dicyclohexylcarbodiimid oder aromatische polymere Carbodiimide, wobei von den polymeren Carbodiimiden solche mit einem Molekulargewicht von 2.000 bis 50.000, erhältlich unter der Bezeichnung ®Stabaxol P von Rhein Chemie GmbH, Mannheim, besonders bevorzugt sind) geeignet, daneben auch Oxazoline. Der Anteil dieser Verbindungen beträgt allgemein 0,1 bis 5,0 Gew.-%, bevorzugt 0,2 bis 3,0 Gew.-%, jeweils bezogen auf das Gewicht der einschichtigen Folie bzw. der damit ausgerüsteten Schicht der mehrschichtigen Folie.

Eine bevorzugte erfindungsgemäße Folie enthält sowohl Verbindungen, die die Hydrolysegeschwindigkeit herabsetzen, als auch Verbindungen, die Esterbindungen wiederherstellen können. Sie ist besonders resistent gegen Feuchtigkeit oder Wasser. In einer bevorzugten Ausführungsform enthält die Folie demgemäß 0,1 bis 5 Gew.-% an polymeren aromatischen Carbodiimiden und 0,1 bis 5 Gew.-% eines Blends aus 30 bis 90 Gew.-% eines organischen Phosphits (insbesondere eines Triarylphosphits) und 70 bis 10 Gew.-% eines Hydroxyphenylpropionats.

Der Anteil aller Hydrolysestabilisatoren zusammen beträgt allgemein 0,2 bis 16,0 Gew.-%, bevorzugt 0,5 bis 14,0 Gew.-%, jeweils bezogen auf das Gewicht der Folie bzw. der betreffenden Schicht der mehrschichtigen Folie.

Anders als UV-Stabilisatoren zeigen die Hydrolysestabilisatoren bei einer Wellenlänge von 380 bis 400 nm praktisch keine oder nur eine vergleichsweise geringe Absorption.

Die erfindungsgemäße Folie zeigt gute mechanische Eigenschaften. Dazu zählen unter anderem ein hoher E-Modul (in Längsrichtung = Maschinenrichtung (MD) größer als 3.500 N/mm$^2$, bevorzugt größer als 3.800 N/mm$^2$; in Querrichtung (TD) größer als 4.200 N/mm$^2$, bevorzugt größer als 4.500 N/mm$^2$; jeweils bestimmt gemäß ISO 527-1-2) sowie gute Reißfestigkeitswerte (in MD mehr als 100 N/mm$^2$, in TD mehr als 180 N/mm$^2$).

Der Schrumpf läßt sich durch entsprechende Wahl der Fixiertemperatur und der Rahmengeometrie über einen weiten Bereich von 0 bis etwa 5 % in Längs- und Querrichtung einstellen. Bevorzugt zeigt die Folie einen niedrigen Schrumpf. Das bedeutet, daß sie in Längs- wie auch in Querrichtung weniger als 1,5%, bevorzugt weniger als 1,3%, besonders bevorzugt weniger als 1,1 % schrumpft, wenn sie 15 min lang auf 150 °C erhitzt wurde (DIN 40 634). Diese Schrumpfwerte können über das Herstellverfahren wie auch durch eine anschließende Off-line-Nachbehandlung erreicht werden. Bei der Off-line-Nachbehandlung wird die Folie weitestgehend ohne Zug durch einen Wärmeofen geführt, wobei sie einer Temperatur im Bereich von 160 bis 210°C 30 Sekunden bis 2 Minuten lang ausgesetzt wird. Beim Herstellprozeß kann der Schrumpf durch Einstellung der Thermofixiertemperatur eingestellt werden. Die Thermofixiertemperatur liegt zwischen 180°C und 260°C, insbesondere zwischen 220°C und 250°C.

Die Folie läßt sich zudem bei ihrer Herstellung sowohl in Längs- als auch in Querrichtung hervorragend und ohne Abrisse orientieren. Die orientierte (= verstreckte) Folie hat allgemein eine Dicke von 1 bis 500 μm, bevorzugt von 5 bis 350 μm, besonders bevorzugt von 10 bis 300 μm.

Ferner besitzt die erfindungsgemäße Folie eine gute Hydrolysebeständigkeit. Das bedeutet, daß sie im Klimatest (Feuchte-Langzeittest) nach 1.000 Stunden bei 85 °C und 95% relativer Luftfeuchte im Autoklaven Reißfestigkeiten von mehr als 100 N/mm$^2$ in Längs- und Querrichtung aufweist.

Zu den guten optischen Eigenschaften der Folie zählen beispielsweise eine hohe Lichttransmission (größer als 80%), eine niedrige Trübung (weniger als 30%) sowie ein niedriger Gelbwert (YID kleiner als 10).

Sie läßt sich auch wirtschaftlich herstellen. So können die Rohstoffe bzw. die Rohstoffkomponenten, die zur Herstellung der Folie benötigt werden, mit üblichen Industrietrocknern, wie Vakuumtrocknern, Wirbelschichttrocknern, Fließbetttrocknem oder Festbetttrocknem (Schachttrocknern), getrocknet werden ohne daß die Rohstoffe verkleben oder thermisch abgebaut werden.

Die Folie versprödet auch nicht bei Temperaturbelastung. Das bedeutet, daß sich die mechanischen Eigenschaften der Folie selbst nach 1.000 Stunden Tempern bei 130 °C in einem Umluftofen nur unwesentlich verschlechtern. Polyethylenterephthalat-Folien ohne Hydrolysestabilisatoren erfüllen diese Anforderungen nicht.

Die erfindungsgemäße Folie enthält als Hauptbestandteil einen kristallisierbaren Thermoplasten, insbesondere einen kristallisierbaren Polyester oder Copolyester. Geeignete kristallisierbare bzw. teilkristalline (Co-)Polyester sind beispielsweise Polyethylenterephthalat (PET), Polyethylennaphthalat (PEN), Polybutylenterephthalat (PBT), bibenzolmodifiziertes Polyethylenterephthalat (PETBB), bibenzolmodifiziertes Polybutylenterephthalat (PBTBB) und bibenzolmodifiziertes Polyethylennaphthalat (PENBB), wobei Polyethylenterephthalat (PET) und bibenzolmodifiziertes Polyethylenterephthalat (PETBB) bevorzugt sind.

Im Rahmen der vorliegenden Erfindung sollen unter "kristallisierbaren Thermoplasten" kristallisierbare Homopolymere, kristallisierbare Copolymere, kristallisierbare Compounds, kristallisierbares Rezyklat oder andere Varianten von kristallisierbaren Thermoplasten verstanden werden.

Zur Herstellung von kristallisierbaren, thermoplastischen (Co-)Polyestern können neben den Hauptmonomeren, wie Dimethylterephthalat (DMT), Ethylenglykol (EG), Propylenglykol (PG), Butan-1,4-diol, Terephthalsäure (TA), Benzoldicarbonsäure und/ oder Naphthalin-2,6-dicarbonsäure (NDA), auch noch Isophthalsäure (IPA) und/ oder *cis*- und/oder *trans*-1,4-Cyclohexan-dimethanol (*c*-CHDM, *t*-CHDM oder *c*/*t*-CHDM) verwendet werden.

Die Standardviskosität SV (DCE) des Polyethylenterephthalats liegt allgemein zwischen 600 und 1.000, vorzugsweise zwischen 700 und 900.

Bevorzugte Ausgangsmaterialien zur Herstellung der erfindungsgemäßen Folie sind kristallisierbare Thermoplaste mit einer Kristallitschmelztemperatur Tm von 180 bis 365 °C und mehr, vorzugsweise von 180 bis 310 °C, einem Kristallisationstemperaturbereich Tc zwischen 75 und 280 °C, einer Glasübergangstemperatur Tg von 65 bis 130 °C (bestimmt durch Differential Scanning Calorimetry (DSC) bei einer Aufheizgeschwindigkeit von 20 °C/min), mit einer Dichte von 1,10 bis 1,45 (bestimmt gemäß DIN 53479) und einer Kristallinität zwischen 5 und 65 %, vorzugsweise 20 und 65 %.

Das Schüttgewicht (gemessen nach DIN 53466) liegt zwischen 0,75 und 1,0 kg/dm$^3$, bevorzugt zwischen 0,80 und 0,90 kg/dm$^3$.

Die Polydispersität (= Verhältnis Mw zu Mn) des Thermoplasten, gemessen durch Gelpermeationschromatographie (GPC), liegt vorzugsweise zwischen 1,5 und 4,0, besonders bevorzugt zwischen 2,0 und 3,5. "Hauptbestandteil" heißt, daß der Anteil des mindestens einen teilkristallinen Thermoplasten bevorzugt zwischen 50 und 99 Gew.-%, besonders bevorzugt zwischen 75 und 95 Gew.-%, beträgt, jeweils bezogen auf das Gesamtgewicht der Folie bzw. das Gesamtgewicht der Schicht in der Folie. Die restlichen Anteile können neben dem Hydrolysestabilisator weitere, für biaxial orientierte, transparente Folien übliche Additive ausmachen.

Die erfindungsgemäße Polyethylenterephthalat-Folie kann sowohl ein- als auch mehrschichtig sein. In der mehrschichtigen Ausführungsform ist die Folie aus mindestes einer Kernschicht, mindestens einer Deckschicht und

gegebenenfalls mindestens einer Zwischenschicht aufgebaut, wobei insbesondere ein dreischichtiger A-B-A oder A-B-C Aufbau bevorzugt ist. Für diese Ausführungsform ist es wesentlich, daß das Polyethylenterephthalat der Kernschicht eine ähnliche Standardviskosität besitzt wie das Polyethylenterephthalat der Deckschicht(en), die an die Kernschicht angrenzt (angrenzen).

In einer besonderen Ausführungsform können die Deckschichten und/oder die Zwischenschichten der mehrschichtigen Folie auch aus einem Polyethylennaphthalat-Homopolymeren oder aus Polyethylenterephthalat/Polyethylennaphthalat-Copolymeren oder einem Compound bestehen. In dieser Ausführungsform haben die Thermoplaste der Deckschichten ebenfalls ähnliche Standardviskositäten wie das Polyethylenterephthalat der Kernschicht.

In der mehrschichtigen Ausführungsform sind der oder die Hydrolysestabilisatoren vorzugsweise in der Basisschicht enthalten. Jedoch können nach Bedarf auch die Deckschichten und/oder eventuell vorhandene Zwischenschichten mit Hydrolysestabilisatoren in der für die Monofolie angegebenen Konzentration ausgerüstet sein. Anders als in der einschichtigen Ausführungsform bezieht sich hier die Konzentration der Stabilisatoren auf das Gewicht der ausgerüsteten Schicht.

Die Lichttransmission L, gemessen nach ASTM D 1003, beträgt mehr als 80%, vorzugsweise mehr als 82% und die Trübung der Folie, gemessen nach ASTM D 1003, beträgt weniger als 30%, vorzugsweise weniger als 25%, was angesichts der erreichten Hydrolysestabilität überraschend gut ist.

Des weiteren ist die erfindungsgemäße Folie ohne Umweltbelastung rezyklierbar, wobei die aus dem Rezyklat hergestellte Folie praktisch keine Verschlechterung in den optischen Eigenschaften (insbesondere beim Gelbwert) oder den mechanischen Eigenschaften gegenüber einer aus neuen Ausgangsmaterialien hergestellten zeigt.

Basisschicht und/oder Deckschicht(en) können neben dem/den Hydrolysestabilisatoren und den bisher beschriebenen Additiven zusätzlich weitere übliche Additive, wie Füllstoffe und Antiblockmittel, enthalten. Sie werden zweckmäßig dem Polymer bzw. der Polymermischung bereits vor dem Aufschmelzen zugesetzt.

Als Additive können auch Mischungen von zwei und mehr verschiedenen Antiblockmitteln oder Mischungen von Antiblockmitteln gleicher Zusammensetzung, aber unterschiedlicher Partikelgröße, gewählt werden. Die Partikel können den einzelnen Schichten in den üblichen Anteilen, z.B. als glykolische Dispersion, während der Polykondensation oder über Masterbatche bei der Extrusion zugegeben werden. Als besonders geeignet haben sich Pigmentanteile von 0,0001 bis 10,0 Gew.-%, bezogen auf das Gewicht der Deckschichten, erwiesen.

Für bestimmte Anwendungen kann es zweckmäßig sein, die Oberfläche der Folie durch Behandlung mit Säuren chemisch vorzubehandeln. Für diese sogenannte Ätzhaftvermittlung eignen sich insbesondere Trichloressigsäure, Dichloressigsäure oder Flußsäure, die für eine kurze Zeit (zwischen 5 und 120 Sekunden) auf die Oberfläche einwirken und dann mittels Luftmesser wieder entfernt werden. Dadurch erhält die Folie eine sehr reaktive, amorphe Oberfläche.

Die erfindungsgemäße Folie kann mindestens eine weitere Funktionalität aufweisen. Die zusätzliche Funktionalität besteht vorzugsweise darin, daß die Folie gegen UV-Strahlung stabilisiert, flammhemmend ausgerüstet, auf einer oder auf beiden Seiten beschichtet, siegelfähig und/oder corona- oder flammbehandelt ist.

So kann die erfindungsgemäße Folie auf einer oder beiden Seiten beschichtet sein. Die Beschichtung hat dabei auf der fertigen Folie allgemein eine Dicke von 5 bis 100 nm, bevorzugt 20 bis 70 nm, insbesondere 30 bis 50 nm. Sie wird bevorzugt In-line aufgebracht, d.h. während des Folienherstellprozesses, zweckmäßigerweise vor der Querverstreckung. Besonders bevorzugt ist die Aufbringung mittels des "Reverse gravure-roll coating"-Verfahrens, bei dem sich die Beschichtung äußerst homogen in der genannten Schichtdicke auftragen läßt. Die Beschichtungen werden - bevorzugt wäßrig - als Lösungen, Suspensionen oder Dispersionen aufgetragen, um der Folienoberfläche zusätzliche Funktionalitäten der eingangs genannten Art zu verleihen. Beispiele für Stoffe oder Zusammensetzungen, die zusätzliche Funktionalität verleihen, sind Acrylate (siehe WO 94/13476), Ethylvinylalkohole, PVDC, Wasserglas ($Na_2SiO_4$), hydrophile Polyester (5-Nasulfoisophthalsäurehaltige PET/IPA-Polyester wie in den EP-A 144 878 oder US-A 4 252 885 genannt), Copolymere mit Vinylacetat-Einheiten (siehe WO 94/13481), Polyvinylacetate, Polyurethane, Alkali- oder Erdalkalisalze von ($C_{10}$-$C_{18}$)Fettsäuren, Copolymere mit Einheiten aus Butadien und Acrylnitril, Methylmethacrylat, Methacrylsäure und/oder Acrylsäure und/oder deren Ester. Die Stoffe oder Zusammensetzungen, die die zusätzliche Funktionalität verleihen, können die üblichen Additive, wie Antiblockmittel und/oder pH-Stabilisatoren, in Mengen von 0,05 bis 5 Gew.-%, vorzugsweise von 0,1 bis 3 Gew.-% enthalten.

Die genannten Stoffe oder Zusammensetzungen werden als verdünnte, vorzugsweise wäßrige Lösung, Emulsion oder Dispersion auf eine oder beide Seiten der Folie aufgebracht. Anschließend wird das Lösungsmittel entfernt. Werden die Beschichtungen In-line vor der Querstreckung aufgebracht, reicht gewöhnlich die Temperaturbehandlung vor der Querstreckung aus, um das Lösungsmittel zu verflüchtigen und die Beschichtung zu trocknen. Die getrockneten Beschichtungen haben dann Schichtdicken von 5 bis 100 nm, bevorzugt 20 bis 70 nm, insbesondere 30 bis 50 nm.

Die erfindungsgemäße Folie kann auch UV-stabil ausgerüstet sein. Licht, insbesondere der ultraviolette Anteil der Sonnenstrahlung, d. h. der Wellenlängenbereich von 280 bis 400 nm, induziert bei Thermoplasten Abbauvorgänge, als deren Folge sich nicht nur das visuelle Erscheinungsbild durch eintretende Farbänderung bzw. Vergilbung ändert, sondern durch die auch die mechanischphysikalischen Eigenschaften der Folien aus den Thermoplasten äußerst negativ beeinflußt werden. Die Unterbindung dieser photooxidativen Abbauvorgänge ist von erheblicher technischer und wirtschaftlicher Bedeutung, da andernfalls die Anwendungsmöglichkeiten von zahlreichen Thermoplasten drastisch eingeschränkt sind. Polyethylenterephthalate beginnen beispielsweise schon unterhalb von 360 nm UV-Licht zu absorbieren, ihre Absorption nimmt unterhalb von 320 nm beachtlich zu und ist unterhalb von 300 nm sehr ausgeprägt. Die maximale Absorption liegt im Bereich zwischen 280 und 300 nm. In Gegenwart von Sauerstoff werden hauptsächlich Kettenspaltungen beobachtet, jedoch keine Vernetzungen. Kohlenmonoxid, Kohlendioxid und Carbonsäuren stellen die mengenmäßig überwiegenden Photooxidationsprodukte dar. Neben der direkten Photolyse der Estergruppen müssen noch Oxidationsreaktionen in Erwägung gezogen werden, die über Peroxidradikale ebenfalls die Bildung von Kohlendioxid zur Folge haben. Die Photooxidation von Polyethylenterephthalaten kann auch über Wasserstoffabspaltung in $\alpha$-Stellung der Estergruppen zu Hydroperoxiden und deren Zersetzungsprodukten sowie zu damit verbundenen Kettenspaltungen führen (H. Day, D. M. Wiles, *J. Appl. Polym. Sci.* **16** [1972] S. 203).

UV-Stabilisatoren, d.h. UV-Absorber als Lichtschutzmittel, sind chemische Verbindungen, die in die physikalischen und chemischen Prozesse des lichtinduzierten Abbaus eingreifen. Ruß und andere Pigmente können teilweise einen Lichtschutz bewirken. Diese Substanzen sind jedoch für transparente Folien ungeeignet, da sie zur Verfärbung oder Farbänderung führen. Geeignete UV-Stabilisatoren als Lichtschutzmittel sind UV-Stabilisatoren, die mindestens 70 %, bevorzugt mindestens 80 %, besonders bevorzugt mindestens 90 %, des UV-Lichts im Wellenlängenbereich von 180 nm bis 380 nm, vorzugsweise 280 bis 350 nm, absorbieren. Besonders geeignete UV-Stabilisatoren sind zudem im Temperaturbereich von 260 bis 300 °C thermisch stabil, d.h. sie zersetzen sich nicht in Spaltprodukte und gasen nicht aus. Geeignete UV-Stabilisatoren als Lichtschutzmittel sind beispielsweise 2-Hydroxy-benzophenone, 2-Hydroxy-benzotriazole, nickelorganische Verbindungen, Salicylsäureester, Zimtsäureester-Derivate, Resorcin-monobenzoate, Oxalsäure-anilide, Hydroxybenzoesäureester, Benzoxazinone, sterisch gehinderte Amine und Triazine, wobei die 2-Hydroxy-benzotriazole, die Benzoxazinone und die Triazine bevorzugt sind. Es war für die Fachwelt völlig überraschend, daß der Einsatz von UV-Stabilisatoren in Kombination mit Hydrolysestabilisatoren zu brauchbaren Folien mit hervorragenden Eigenschaften führt.

Aus der Literatur sind UV-Stabilisatoren bekannt, die UV-Strahlung absorbieren und somit Schutz bieten. Der Fachmann hätte dann wohl einen dieser bekannten und handelsüblichen UV-Stabilisatoren eingesetzt, dabei jedoch festgestellt, daß der UV-Stabilisator eine mangelnde thermische Stabilität hat und sich bei Temperaturen zwischen 200 und 240 °C zersetzt oder ausgast. Um die Folie nicht zu schädigen, hätte er große Mengen (ca. 10 bis 15 Gew.-%) an UV-Stabilisator einarbeiten müssen, damit dieser das UV-Licht wirklich wirksam absorbiert. Bei diesen hohen Konzentrationen vergilbt jedoch die Folie schon in kurzer Zeit nach der Herstellung. Auch die mechanischen Eigenschaften werden negativ beeinflußt. Beim Verstrecken tauchen ungewöhnliche Probleme auf, wie Abrisse wegen mangelnder Festigkeit, d.h. E-Modul, Düsenablagerungen, was zu Profilschwankungen führt, Ablagerung von UV-Stabilisator auf den Walzen, was zur Beeinträchtigung der optischen Eigenschaften (starke Trübung, Klebedefekt, inhomogene Ober fläche) führt, und Ablagerungen im Streck- und Fixierrahmen, die auf die Folie tropfen. Es war daher überraschend, daß bereits mit niedrigen Konzentrationen des UV-Stabilisators ein hervorragender UV-Schutz erzielt wird.

In einer ganz besonders bevorzugten Ausführungsform enthält die erfindungsgemäße Folie als UV-Stabilisator 0,1 bis 5,0 Gew.-% 2-(4,6-Diphenyl-[1,3,5]triazin-2-yl)-5-hexyloxy-phenol der Formel

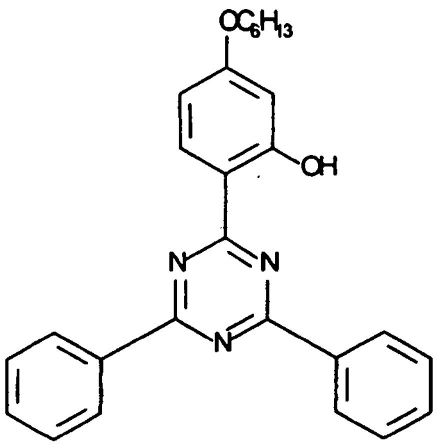

oder 0,1 bis 5,0 Gew.-% 2,2'-Methylen-bis-[6-benzotriazol-2-yl-4-(1,1,2,2-tetramethyl-propyl)-phenol] der Formel

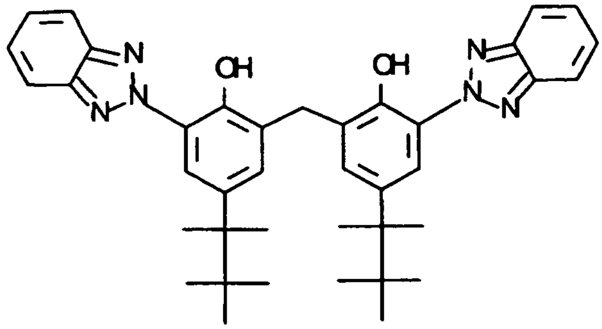

oder 0,1 bis 5,0 Gew.-% 2,2'-(1,4-Phenylen)-bis-([3,1]benzoxazin-4-on) der Formel

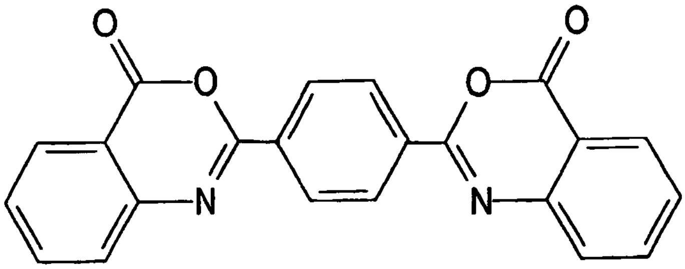

In einer weiteren Ausführungsform können auch Mischungen dieser UV-Stabilisatoren oder Mischungen von mindestens einem dieser UV-Stabilisatoren mit anderen UV-Stabilisatoren eingesetzt werden, wobei die Gesamtkonzentration an Lichtschutzmittel vorzugsweise zwischen 0,1 und 5,0 Gew.-%, besonders bevorzugt im Bereich von 0,5 bis 3,0 Gew.-%, liegt, bezogen auf das Gewicht der ausgerüsteten Schicht.

In einer weiteren Ausführungsform ist die erfindungsgemäße Folie flammhemmend ausgerüstet. Flammhemmend bedeutet, daß die Folie in einer sogenannten Brandschutzprüfung die Bedingungen nach DIN 4102 Teil 2 und insbesondere die Bedingungen nach DIN 4102 Teil 1 erfüllt und in die Baustoffklasse B 2 und insbesondere B1 der schwer entflammbaren Stoffe eingeordnet werden kann. Des weiteren soll die gegebenenfalls flammhemmend ausgerüstete Folie den UL-Test 94 "Burning Test for Flammability of Plastic Material" bestehen, so daß sie in die Klasse 94 VTM-0 eingestuft werden kann. Die Folie enthält demgemäß ein Flammschutzmittel, das über die sogenannte Masterbatch-Technologie direkt bei der Folienherstellung zudosiert wird, wobei der Anteil des Flammschutzmittels im Bereich von 0,2 bis 30,0 Gew.-%, bevorzugt 0,5 bis 25 Gew.-%, besonders bevorzugt von 1,0 bis 20,0 Gew.-%, bezogen auf das Gewicht der Schicht des kristallisierbaren Thermoplasten, liegt. Im Masterbatch beträgt der Anteil des Flammschutzmittels allgemein 5 bis 60 Gew.-%, bevorzugt 10 bis 50 Gew.-%, jeweils bezogen auf das Gesamtgewicht des Masterbatches. Geeignete Flammschutzmittel sind beispielsweise Bromverbindungen, Chlorparaffine und andere Chlorverbindungen, Antimontrioxid und Aluminiumtrihydrate. Die Halogenverbindungen haben allerdings den Nachteil, daß dabei halogenhaltige Nebenprodukte entstehen können. Im Brandfall entstehen insbesondere Halogenwasserstoffe. Nachteilig ist auch die geringe Lichtbeständigkeit einer damit ausgerüsteten Folie. Weitere geeignete Flammschutzmittel sind beispielsweise organische Phosphorverbindungen wie Carboxyphosphinsäuren, deren Anhydride und Methanphosphonsäuredimethylester. Wesentlich ist, daß die organische Phosphorverbindung im Thermoplast löslich ist, da andernfalls die geforderten optischen Eigenschaften nicht erfüllt werden.

Da die Flammschutzmittel im allgemeinen eine gewisse Hydrolyseempfindlichkeit aufweisen, kann der zusätzliche Einsatz eines Hydrolysestabilisators sinnvoll sein.

In dieser bevorzugten Ausführungsform enthält die erfindungsgemäße schwer entflammbare Folie als Hauptbestandteil ein kristallisierbares Polyethylenterephthalat, 1 Gew.-% bis 20 Gew.-% einer im Thermoplasten löslichen organischen Phosphorverbindung als Flammschutzmittel und 0,1 Gew.-% bis 1,0 Gew.-% eines Hydrolysestabilisators. Als Flammschutzmittel ist Methanphosphonsäure-dimethylester bevorzugt. Diese Anteile an Flammschutzmittel und Hydrolysestabilisator haben sich auch dann als günstig erwiesen, wenn der Hauptbestandteil der Folie nicht Polyethylenterephthalat, sondern ein anderer Thermoplast ist.

Ganz überraschend haben Brandschutzversuche nach DIN 4102 und dem UL-Test gezeigt, daß es im Falle einer dreischichtigen Folie durchaus ausreichend ist, die 0,5 bis 2 μm dicken Deckschichten mit Flammschutzmitteln auszurüsten, um eine verbesserte Flammhemmung zu erreichen. Bei Bedarf und bei hohen Brandschutzanforderungen

kann auch die Kernschicht mit Flammschutzmitteln ausgerüstet sein, d. h. eine sogenannte Grundausrüstung beinhalten.

Darüber hinaus ergaben Messungen, daß die erfindungsgemäße Folie bei Temperaturbelastungen von 100 °C über einen längeren Zeitraum nicht versprödet. Dieses Resultat wird auf die synergistische Wirkung von geeigneter Vorkristallisation, Vortrocknung, Masterbatch-Technologie und Hydrolysestabilisator zurückgeführt.

Wo eine sehr gute Siegelfähigkeit gefordert wird und wo diese Eigenschaft nicht über eine On-line Beschichtung erreicht werden kann, ist die erfindungsgemäße Folie zumindest dreischichtig aufgebaut und umfaßt dann in einer besonderen Ausführungsform die Basisschicht B, eine siegelfähige Deckschicht A und eine gegebenenfalls siegelfähige Deckschicht C. Ist die Deckschicht C ebenfalls siegelfähig, dann sind die beiden Deckschichten vorzugsweise identisch.

Die durch Coextrusion auf die Basisschicht B aufgebrachte siegelfähige Deckschicht A ist auf Basis von Polyestercopolymeren aufgebaut und besteht im wesentlichen aus Copolyestern, die überwiegend aus Isophthalsäure-, Bibenzolcarbonsäure- und Terephthalsäure-Einheiten und aus Ethylenglykol-Einheiten zusammengesetzt sind. Die restlichen Monomereinheiten stammen aus anderen aliphatischen, cycloaliphatischen oder aromatischen Diolen bzw. Dicarbonsäuren, wie sie auch in der Basisschicht vorkommen können. Die bevorzugten Copolyester, die die gewünschten Siegeleigenschaften bereitstellen, sind solche, die aus Etylenterephthalat- und Ethylenisophthalat-Einheiten und aus Ethylenglykol-Einheiten aufgebaut sind. Der Anteil an Ethylenterephthalat beträgt 40 bis 95 mol-% und der entsprechende Anteil an Ethylenisophthalat 60 bis 5 mol-%. Bevorzugt sind Copolyester, bei denen der Anteil an Ethylenterephthalat 50 bis 90 mol-% und der entsprechende Anteil an Ethylenisophthalat 50 bis 10 mol-% beträgt und ganz bevorzugt sind Copolyester, bei denen der Anteil an Ethylenterephthalat 60 bis 85 mol-% und der entsprechende Anteil an Ethylenisophthalat 40 bis 15 mol-% beträgt.

Für die gegebenenfalls siegelfähige Deckschicht C und für eventuelle Zwischenschichten können prinzipiell die gleichen Polymeren verwendet werden, die auch in der Basisschicht Verwendung finden.

Die gewünschten Siegel- und Verarbeitungseigenschaften der erfindungsgemäßen Folie werden aus der Kombination der Eigenschaften des verwendeten Copolyesters für die siegelfähige Deckschicht und den Topographien der siegelfähigen Deckschicht A und der gegebenenfalls siegelfähigen Deckschicht C erhalten.

Die Siegelanspringtemperatur von 110 °C und die Siegelnahtfestigkeit von mindestens 1,3 N/15mm wird erreicht, wenn für die siegelfähige Deckschicht A die oben näher beschriebenen Copolymere verwendet werden. Die besten Siegeleigenschaften der Folie erhält man, wenn dem Copolymeren keine weiteren

Additive, insbesondere keine anorganische oder organische Filler zugegeben werden. Für diesen Fall erhält man bei vorgegebenem Copolyester die niedrigste Siegelanspringtemperatur und die höchsten Siegelnahtfestigkeiten. Allerdings ist in diesem Fall das Handling der Folie schlecht, da die Oberfläche der siegelfähigen Deckschicht A stark zum Verblocken neigt. Die Folie läßt sich kaum wickeln und ist für eine Weiterverarbeitung auf schnelllaufenden Verpackungsmaschinen nicht geeignet. Zur Verbesserung des Handlings der Folie und der Verarbeitbarkeit ist es notwendig, die siegelfähige Deckschicht A zu modifizieren. Dies geschieht am besten mit Hilfe von geeigneten Antiblockmitteln einer ausgewählten Größe, die in einer bestimmten Konzentration der Siegelschicht zugegeben werden und zwar derart, daß einerseits das Verblocken minimiert und andererseits die Siegeleigenschaften nur unwesentlich verschlechtert werden.

Zwischen der Basisschicht und den Deckschicht/en kann sich gegebenenfalls noch eine Zwischenschicht befinden. Sie kann aus den für die Basisschicht beschriebenen Polymeren bestehen. In einer besonders bevorzugten Ausführungsform besteht sie aus dem für die Basisschicht verwendeten Polyester. Sie kann neben dem/den Hydrolysestabilisatoren auch weitere übliche Additive enthalten. Die Dicke der Zwischenschicht ist im allgemeinen größer als 0,3 μm und liegt vorzugsweise im Bereich von 0,5 bis 15 μm, insbesondere 1,0 bis 10 μm.

Die Dicke der Deckschicht/en ist im allgemeinen größer als 0,1 μm und liegt vorzugsweise im Bereich von 0,2 bis 5 μm, insbesondere 0,2 bis 4 μm, wobei die Deckschichten gleich oder verschieden dick sein können.

Die Gesamtdicke der erfindungsgemäßen Polyesterfolie kann innerhalb weiter Grenzen variieren und richtet sich nach dem beabsichtigten Verwendungszweck. Sie beträgt vorzugsweise 1 bis 500 μm, insbesondere 5 bis 350 μm, vorzugsweise 10 bis 300 μm, wobei die Basisschicht einen Anteil von vorzugsweise etwa 40 bis 90 % an der Gesamtdicke hat.

Zur Einstellung weiterer gewünschter Eigenschaften kann die Folie auch corona- bzw. flammbehandelt sein. Die Behandlung wird üblicherweise so durchgeführt, daß die Oberflächenspannung der Folie danach im allgemeinen über 45 mN/m liegt.

In einer weiteren Ausführungsform ist die erfindungsgemäße Folie transparent eingefärbt. Dann enthält sie mindestens einen im Thermoplast löslichen Farbstoff, wobei der Anteil des löslichen Farbstoffs allgemein 0,01 bis 20,0 Gew.-%, bevorzugt 0,05 bis 10,0 Gew.-%, beträgt, jeweils bezogen auf das Gewicht des kristallisierbaren Thermoplasten. Als löslichen Farbstoff werden hier solche bezeichnet, die im Polymeren molekular gelöst sind (DIN 55949). Die farbliche Veränderung der Folie beruht auf der wellenlängenabhängigen Absorption und/oder Streuung des Lichtes. Farbstoffe können Licht nur absorbieren, aber nicht streuen, da eine bestimmte Teilchengröße die physikalische Voraussetzung für eine Streuung ist. Bei der Einfärbung mit Farbstoff handelt es sich um einen Lösungsprozeß. Als Ergebnis dieses Lösungsprozesses ist der Farbstoff molekular beispielsweise in dem kristallisierbaren Thermoplasten gelöst. Derartige

Einfärbungen werden als transparent, durchscheinend, transluzent oder opal bezeichnet. Von den verschiedenen Klassen der löslichen Farbstoffe werden besonders die fett- und aromatenlöslichen Farbstoffe bevorzugt. Dabei handelt es sich beispielsweise um Azo- und Anthrachinonfarbstoffe. Sie eignen sich insbesondere z.B. zur Einfärbung von Polyethylenterephthalat, da aufgrund der hohen Glasübergangstemperaturen von Polyethylenterephthalat die Migration des Farbstoffes eingeschränkt ist. (siehe J. Koerner, *Lösliche Farbstoffe in der Kunststoffindustrie* in "VDI-Gesellschaft Kunststofftechnik:", Einfärben von Kunststoffen, VDI-Verlag, Düsseldorf 1975). Geeignete lösliche Farbstoffe sind beispielsweise: C.I. Solventgelb 93 (ein Pyrazolonderivat), C.I.Solventgelb 16 (ein fettlöslicher Azofarbstoff), Fluorolgrüngold (ein fluoreszierender polycyclischer Farbstoff), C.I.Solventrot 1 (ein Azofarbstoff), Azofarbstoffe wie Thermoplastrot BS, Sudanrot BB, C.I.Solventrot 138 (ein Anthrachinonderivat), fluoreszierende Benzopyranfarbstoffe wie Fluorolrot GK und Fluorolorange GK, C.I.Solventblau 35 (ein Anthrachinonfarbstoff), C.I.Solventblau 15:1 (ein Phthalocyaninfarbstoff) und viele andere. Geeignet sind auch Mischungen von zwei oder mehreren dieser löslichen Farbstoffe.

Der lösliche Farbstoff wird bevorzugt ebenfalls in Form eines Masterbatches zudosiert, kann aber auch direkt beim Rohstoffhersteller eingearbeitet werden. Der Anteil an löslichen Farbstoff(en) beträgt allgemein 0,01 bis 40 Gew.-%, bevorzugt 0,05 bis 25 Gew.-%, jeweils bezogen auf das Gewicht des kristallisierbaren Thermoplasten.

Gegenstand der vorliegenden Erfindung ist auch ein Verfahren zur Herstellung der Folie. Allgemein erfolgt die Herstellung durch ein Extrusions- oder Coextrusionsverfahren, beispielsweise auf einer Extrusionsstraße. Als besonders vorteilhaft hat es sich erwiesen, den mindestens einen Hydrolysestabilisator in Form eines vorgetrockneten oder vorkristallisierten Masterbatches vor der Extrusion oder Coextrusion zuzugeben. Der Anteil an Hydrolysestabilisator(en) im Masterbatch beträgt allgemein 5 bis 50 Gew.-%, bevorzugt 6 bis 30 Gew.-%, jeweils bezogen auf das Gesamtgewicht des Masterbatches. Der bzw. die Hydrolysestabilisator(en) werden in einem Trägermaterial voll dispergiert. Als Trägermaterial kommen der Thermoplast selbst, z. B. Polyethylenterephthalat oder auch andere Polymere, die mit dem Thermoplasten verträglich sind, in Frage.

Bevorzugt bei der Masterbatch-Technologie ist, daß die Korngröße und das Schüttgewicht der Masterbatche ähnlich der Korngröße und dem Schüttgewicht des Thermoplasten ist, so daß eine homogene Verteilung erreicht wird, aus der homogene Eigenschaften resultieren.

Die Polyesterfolien können nach bekannten Verfahren aus einem Polyesterrohstoff, gegebenenfalls weiteren Rohstoffen, mindestens einem Hydrolysestabilisator sowie gegebenenfalls weiteren üblichen Additiven (letztere in üblicher Menge von 0,1 bis 30 Gew.-%, bezogen auf das Gewicht der Folie) sowohl als Monofolie als auch als mehrschichtige - gegebenenfalls coextrudierte - Folien mit gleichen oder unter schiedlich ausgebildeten Oberflächen hergestellt werden, wobei eine Oberfläche beispielsweise Partikel enthält und die andere nicht oder alle Schichten Partikel enthalten. Ebenso können eine oder beide Oberflächen der Folie nach bekannten Verfahren mit einer funktionalen Beschichtung versehen werden.

Masterbatche, die den oder die Hydrolysestabilisator(en) enthalten, sollten vorkristallisiert oder vorgetrocknet sein. Das gleiche gilt für Masterbatche, die Flammschutzmittel oder UV-Stabilisator(en) enthalten. Diese Vortrocknung beinhaltet ein graduelles Erhitzen der Masterbatche unter reduziertem Druck (20 bis 80 mbar, vorzugsweise 30 bis 60 mbar, insbesondere 40 bis 50 mbar) sowie Rühren und gegebenenfalls ein Nachtrocknen bei konstanter, erhöhter Temperatur (ebenfalls unter reduziertem Druck). Die Masterbatche werden vorzugsweise bei Raumtemperatur aus einem Dosierbehälter in der gewünschten Abmischung zusammen mit den Polymeren der Basis- und/oder Deckschichten und ggf. anderen Rohstoffkomponenten chargenweise in einen Vakuumtrockner, der im Laufe der Trocken- bzw. Verweilzeit ein Temperaturspektrum von 10 bis 160°C, vorzugsweise 20 bis 150°C, insbesondere 30 bis 130°C durchläuft, gefüllt. Während der etwa 6-stündigen, vorzugsweise 5-stündigen, insbesondere 4-stündigen, Verweilzeit wird die Rohstoffmischung mit 10 bis 70 Upm, vorzugsweise 15 bis 65 Upm, insbesondere 20 bis 60 Upm, gerührt. Das so vorkristallisierte bzw. vorgetrocknete Rohstoffgemisch wird in einem nachgeschalteten ebenfalls evakuierten Behälter bei 90 bis 180 °C, vorzugsweise 100 bis 170°C, insbesondere 110 bis 160 °C, für 2 bis 8 Stunden, vorzugsweise 3 bis 7 Stunden, insbesondere 4 bis 6 Stunden, nachgetrocknet.

Bei dem bevorzugtem Extrusionsverfahren zur Herstellung der Folie wird das aufgeschmolzene Polymermaterial mit den Additiven durch eine Schlitzdüse extrudiert und als weitgehend amorphe Vorfolie auf einer Kühlwalze abgeschreckt. Diese Folie wird anschließend erneut erhitzt und in Längs- und Querrichtung bzw. in Quer- und Längsrichtung bzw. in Längs-, in Quer- und nochmals und Längsrichtung und/oder Querrichtung verstreckt ("orientiert"). Die Strecktemperaturen liegen im allgemeinen 10 bis 60 °C über der Glas-Übergangstemperatur $T_g$ der Folie, das Streckverhältnis der Längsstreckung liegt üblicherweise bei 2 bis 6, insbesondere bei 3 bis 4,5, das der Querstreckung bei 2 bis 5, insbesondere bei 3 bis 4,5, und das der gegebenenfalls durchgeführten zweiten Längs- und Querstreckung bei 1,1 bis 5. Die erste Längsstreckung kann auch gleichzeitig mit der Querstreckung (Simultanstreckung) durchgeführt werden. Es folgt die Thermofixierung der Folie bei Ofentemperaturen von 180 bis 260 °C, insbesondere von 220 bis 250 °C. Anschließend wird die Folie abgekühlt und gewickelt.

Es war überraschend, daß durch die Masterbatch-Technologie, kombiniert mit einer geeigneten Vortrocknung und/oder Vorkristallisation, und dem Einsatz von Hydrolysestabilisatoren eine hydrolyse- und hochtemperaturstabile Folie mit dem geforderten Eigenschaftsprofil ohne technische Probleme (wie Verklebungen im Trockner) herstellbar ist.

Es wurden bei der Herstellung kaum oder keine Ablagerungen an den Düsen oder Rahmenausdampfungen beobachtet, wodurch die erfindungsgemäße Folie eine exzellente Optik, ein ausgezeichnetes Profil und eine ausgezeichnete Planlage aufweist. Sie läßt sich hervorragend verstrecken, so daß sie verfahrenssicher und wirtschaftlich rentabel hergestellt werden kann. Des weiteren ist es sehr überraschend, daß auch das Regenerat wieder einsetzbar ist, ohne den Gelbwert der Folie negativ zu beeinflussen. Auch im Vergleich zu einer nicht ausgerüsteten Folie ist der Gelbwert im Rahmen der Meßgenauigkeit nicht negativ verändert.

Unerwartet war ferner, daß die erfindungsgemäße Folie auch in der flammfesten Ausführungsform den Klimatest der Automobilindustrie besteht und nicht versprödet.

Durch die Kombination ihrer Eigenschaften eignen sich die erfindungsgemäßen Folien für eine Vielzahl verschiedener Anwendungen, beispielsweise im Innen- und Außenbereich, auf dem Bausektor und im Messebau, im Laden- und Regalbau, im Elektronikbereich und auf dem Beleuchtungssektor, für Gewächshäuser, Innenraumverkleidungen, Messe- und Werbeartikel, Lichtwerbeprofile, flexible Leiter in der Automobilindustrie, Schutzverglasungen von Maschinen und Fahrzeugen, Flachkabel, flexible, gedruckte Schaltungen, Kondensatoren,Displays, Schilder, Kaschiermedium, Schattenmatten, Elektroanwendungen.

Die Erfindung wird im Folgenden anhand von Ausführungsbeispielen näher erläutert, ohne darauf beschränkt zu sein. Die Folieneigenschaften wurden wie folgt geprüft:

**Klimatest (Feuchte-Langzeittest)**

In diesem Test wurde die Folie 1000 h bei 85°C und 95% relativer Luftfeuchte im Autoklaven unter Normaldruck gelagert. Nach der Lagerung wurde die Reißfestigkeit in Längs- und Querrichtung nach ISO 527-1-2 gemessen.

**Hochtemperaturfestigkeit**

Die Hochtemperaturfestigkeit wurde gemäß IPC TM 650 2.4.9 nach 1.000 h Temperung bei 130°C im Umlufttrockenschrank bestimmt.

Nach der Lagerung bzw. nach der Temperung im Klima- bzw. im Hochtemperaturtest muß die Reißfestigkeit nach ISO 527-1-2 bei mehr als 100 $N/mm^2$ liegen, um die Anforderungen der Automobilindustrie zu erfüllen.

**Lichttransmission (Transparenz)**

Unter der Lichttransmission ist das Verhältnis des insgesamt durchgelassenen Lichtes zur einfallenden Lichtmenge zu verstehen. Die Lichttransmission wurde mit dem Messgerät ®HAZEGARD plus von Byk Gardener, Deutschland, gemäß ASTM D 1003 gemessen.

**Trübung**

Trübung ist der prozentuale Anteil des durchgelassenen Lichtes, der vom eingestrahlten Lichtbündel im Mittel um mehr als 2,5° abweicht. Die Bildschärfe wurde unter einem Winkel kleiner 2,5° ermittelt. Die Trübung wurde mit dem gleichen Messgerät und gemäß der gleichen Norm bestimmt wie die Lichttransmission.

**Gelbwert**

Der Gelbwert (YID) ist die Abweichung von der Farblosigkeit in Richtung "Gelb" und wurde gemäß DIN 6167 gemessen.

**Oberflächendefekte**

Die Oberflächendefekte wurden visuell bestimmt.

**Mechanische Eigenschaften**

Der E-Modul und die Reißfestigkeit wurden in Längs- und Querrichtung nach ISO 527-1-2 gemessen.

**Schrumpf**

Der Schrumpf wurde gemäß DIN 40634 bei 150°C und 15 Minuten Verweildauer gemessen.

**Standardviskosität (SV) und intrinsische Viskosität (IV)**

Die Standardviskosität SV wurde - angelehnt an DIN 53726 - als 1%ige Lösung in Dichloressigsäure (DCE) bei 25°C gemessen. SV (DCE) = ($\eta_{rel}$ -1) x 1000. Die intrinsische Viskosität (IV) berechnet sich wie folgt aus der Standardviskosität (SV)

$$IV = [\eta] = 6{,}907 \cdot 10^{-4}\ SV\ (DCE) + 0{,}063096\ [dl/g]$$

**Bewitterung (beidseitig), UV-Stabilität**

Die UV-Stabilität wurde nach der Testspezifikation ISO 4892 wie folgt geprüft:

| | |
|---|---|
| Testgerät | Atlas Ci 65 Weather Ometer |
| Testbedingungen | gemäß ISO 4892, d. h. künstliche Bewitterung |
| Bestrahlungszeit | 1000 Stunden (pro Seite) |
| Bestrahlung | 0,5 W/m$^2$, 340 nm |
| Temperatur | 63°C |
| Relative Luftfeuchte | 50 % |
| Xenonlampe | innerer und äußerer Filter aus Borosilikat |
| Bestrahlungszyklen | 102 Minuten UV-Licht, dann 18 Minuten UV-Licht mit Wasserbesprühung der Proben dann wieder 102 Minuten UV-Licht usw. |

**Brandverhalten**

Das Brandverhalten wurde nach DIN 4102 Teil 2, Baustoffklasse B2 und nach DIN 4102 Teil 1, Baustoffklasse B1 sowie nach dem UL-Test 94 ermittelt.

**Bestimmung der Siegelanspringtemperatur (Mindestsiegeltemperatur)**

Mit dem Siegelgerät HSG/ET der Firma Brugger wurden heißgesiegelte Proben (Siegelnaht 20 mm x 100 mm) hergestellt, wobei die Folie bei unterschiedlichen Temperaturen mit Hilfe zweier beheizter Siegelbacken bei einem Siegeldruck von 2 bar und einer Siegeldauer von 0,5 s gesiegelt wurde. Aus den gesiegelten Proben wurden Prüfstreifen von 15 mm Breite geschnitten. Die T-Siegelnahtfestigkeit wurde wie bei der Bestimmung der Siegelnahtfestigkeit gemessen. Die Siegelanspringtemperatur ist die Temperatur, bei der eine Siegelnahtfestigkeit von mindestens 0,5 N/mm$^2$ erreicht wird.

**Siegelnahtfestigkeit**

Zur Bestimmung der Siegelnahtfestigkeit wurden zwei 15 mm breite Folienstreifen übereinandergelegt und bei 130°C, einer Siegelzeit von 0,5 s und einem Siegeldruck von 2 bar (Gerät: Brugger Typ NDS, einseitig beheizte Siegelbacke) gesiegelt. Die Siegelnahtfestigkeit wurde nach der T-Peel-Methode bestimmt.

**Beispiele**

Bei den nachstehenden Beispielen und Vergleichsbeispielen handelt es sich jeweils um ein- oder mehrschichtige, transparente Folien, die auf einer Extrusionsstraße hergestellt wurden. Sofern nichts anderes angegeben ist, sind die Folien jeweils 75 µm dick. Wenn nichts anderes angeben ist, wird in den Beispielen jeweils der Polyethylentherephthalat-Gehalt um die Gewichtsprozente der verschiedenen Zusätze reduziert.

Das Polyethylenterephthalat (Klarrohstoff), aus dem die transparente Folie hergestellt wurde, hatte eine Standardviskosität SV (DCE) von 810, was einer intrinsischen Viskosität IV (DCE) von 0,658 dl/g entspricht (Polyethylenterephthalat RT49 von KoSa, Deutschland), oder eine Standardviskosität SV (DCE) von 770, was einer intrinsischen Viskosität IV (DCE) von 0,632 dl/g entspricht (Polyethylenterephthalat 4020 von KoSa, Deutschland).

Die Folien wurden nach der Testspezifikation ISO 4892 beidseitig je 1000 Stunden pro Seite mit dem Atlas Ci 65 Weather Ometer der Fa. Atlas bewittert und anschließend bezüglich der mechanischen Eigenschaften, der Verfärbung, der Oberflächendefekte, der Trübung und des Glanzes geprüft.

Die Additive zur Erzielung des Hydrolyseschutzes und der zusätzlichen Funktionalitäten wurden in Form von verschiedenen Masterbatchen zudosiert:

*Masterbatch MB1:*
6 Gew.-% eines phenolischen Hydrolysestabilisators (®Irganox B561, ein Blend aus 80 Gew.-% Irgafos® 168 und 20 Gew.-% ®Irganox 1010; Ciba Specialty Chemicals, Basel, Schweiz),
94 Gew.-% Polyethylenterephthalat (im Folgenden PET genannt) Schüttgewicht: 750 kg/$m^3$

*Masterbatch MB2:*
20 Gew.-% eines aromatischen polymeren Carbodiimids (®Stabaxol P von Rhein Chemie, Mannheim, Deutschland),
80 Gew.-% PET
Schüttgewicht: 750 kg/$m^3$

Zur Herstellung von UV-stabilisierten Folien wurde folgendes Masterbatch eingesetzt:

*Masterbatch MB3:*
20 Gew.-% 2-(4.6-Dipheny)-[1,3,5]triazin-2-yl)-5-hexytoxy-pheno) (®Tinuvin 1577 von Ciba Specialty Chemicals) und
80 Gew.-% PET

Zur Verbesserung der Schlupfeigenschaften wurde folgendes Masterbatch eingesetzt:

*Masterbatch MB4:*
Es enthielt neben PET 10.000 ppm ®Sylobloc 44H (Fa. Grace, Deutschland).

Zur Herstellung einer flammhemmend ausgerüsteten Folie wurde folgendes Masterbatch eingesetzt:

*Masterbatch MB5:*
25 Gew.-% Methanphosphonsäure-dimethylester (®Amgard P1045 von Albright & Wilson Americas, USA) und
75 Gew.-% PET

Zur Herstellung einer transparent eingefärbten Folie wurde folgendes Masterbatch eingesetzt:

*Masterbatch MB6:*
20 Gew.-% Solventblau 35 (fettlöslicher Anthrachinon-Farbstoff, ®sudanblau 2, BASF, Deutschland) und
80 Gew.-% PET

<u>Beispiel 1</u>

Es wurde eine Monofolie hergestellt, die als Hauptbestandteil PET, 0,2 Gew.-% Siliciumdioxid (Sylobloc®, Grace, Worms, Deutschland) als Antiblockmittel und 10 Gew.-% MB2 enthielt.

Zwecks homogener Verteilung wurde das Siliciumdioxid, das im PET nicht löslich ist, beim Rohstoffhersteller in das PET eingearbeitet.

Das PET hatte eine Standardviskosität SV (DCE) von 810, was einer intrinsischen Viskosität IV (DCE) von 0,658 dl/g entspricht.

60 Gew.-% PET, 30 Gew.-% PET-Rezyklat und 10 Gew.-% des Masterbatches MB2 wurden bei Raumtemperatur aus separaten Dosierbehältern in einen Vakuumtrockner gefüllt, der vom Einfüllzeitpunkt bis zum Ende der Verweilzeit ein Temperaturspektrum von 25 bis 130 °C durchlief. Während der ca. 4-stündigen Verweilzeit wurde das Rohstoffgemisch mit 61 Upm gerührt.

Das vorkristallisierte bzw. vorgetrocknete Rohstoffgemisch wurde in dem nachgeschalteten, ebenfalls unter Vakuum stehenden Hopper bei 140 °C 4 Stunden nachgetrocknet. Anschließend wurde die Folie mit dem beschriebenen Extrusionsverfahren hergestellt.

Beispiel 2

Es wurde eine Monofolie aus 51 Gew.-% PET (RT49), 10 Gew.-% MB2, 4 Gew.-% MB4 sowie 35 Gew.-% immanent anfallendem Regenerat wie in Beispiel 1 beschrieben hergestellt.

Beispiel 3

Die Folie aus Beispiel 2 wurde in einem Wärmeofen weitestgehend zuglos bei einer Temperatur von 200°C und einer Verweildauer von 60 Sekunden nachbehandelt.

Beispiel 4

Die Folie aus Beispiel 2 wurde mit Trichloressigsäure beidseitig chemisch nachbehandelt.

Beispiel 5

In Abänderung zu Beispiel 1 enthielt die Folie 2 Gew.-% MB1 und 10 Gew.-% MB2. Das Masterbatch wurde zusammen mit den anderen Rohstoffkomponenten wie in Beispiel 1 beschrieben vorgetrocknet.

Beispiel 6

Die analog Beispiel 2 hergestellte Monofolie enthielt neben 56 Gew.-% PET RT49 5 Gew.-% MB2, 4 Gew.-% MB4 und 35 Gew.-% Regenerat. Die Rohstoffmischung wurde wie in Beispiel 2 beschrieben vorgetrocknet.

Beispiel 7

Die gemäß Beispiel 1 hergestellte Folie enthielt 0,2 Gew.-% Siliciumdioxid, 10 Gew.-% MB1 und 10 Gew.-% MB2.

Beispiel 8

Durch Coextrusion wurde eine dreischichtige PET-Folie mit der Schichtabfolge A-B-A hergestellt, wobei B die Kernschicht und A die Deckschichten repräsentieren. Die Dicke der Kernschicht betrug 71 μm, die der beiden Deckschichten jeweils 2 μm. Für Kernschicht und Deckschichten wurde PET aus Beispiel 1 eingesetzt. Die Kernschicht enthielt zudem 10 Gew.-% MB2, aber kein Siliciumdioxid; die Deckschichten dagegen 0,2 Gew.-% Siliciumdioxid, jedoch keinen Hydrolysestabilisator.

Beispiel 9

Beispiel 8 wurde wiederholt. Beide Deckschichten enthielten jedoch zusätzlich 5 Gew.-% MB2.

Beispiel 10

Es wurde eine hydrolysestabile A-B-A-Folie mit folgender Rezeptur hergestellt:

| | |
|---|---|
| Basisschicht (72 μm dick): | 55 Gew.-% PET 4020, 10 Gew.-% MB2 sowie 35 Gew.-% immanent angefallenes Regenerat. |
| Deckschichten A (je 1,5 μm): | 83 Gew.-% PET 4020, 7 Gew.-% MB4 sowie 10 Gew.-% MB1. |

Vergleichsbeispiel 1

Es wurde eine Folie wie in Beispiel 1 hergestellt, die jedoch keinen Hydrolysestabilisator enthielt.

Beispiel 11

Es wurde eine Folie wie in Beispiel 1 hergestellt, die jedoch zusätzlich 10 Gew.-% MB5 enthielt. Der Anteil an PET wurde entsprechend reduziert.

Beispiel 12

Analog zu Beispiel 8 wurde eine mehrschichtige PET-Folie mit der Schichtabfolge A-B-A hergestellt. Die Dicke der Kernschicht betrug jedoch 73 μm, die der beiden Deckschichten jeweils 1 μm. Die Kernschicht enthielt 10 Gew.-% MB2 und zusätzlich 10 Gew.-% MB5 (Flammschutzmittel). In den Deckschichten fehlten Hydrolysestabilisator(en) und Flammschutzmittel.

Beispiel 13

Entsprechend Beispiel 12 wurde eine koextrudierte A-B-A-Folie hergestellt, wobei die Kernschicht 71 μm und die Deckschichten jeweils 2 μm dick waren. Die Rezeptur der Kernschicht war identisch mit der aus Beispiel 12; sie enthielt also neben PET Flammschutzmittel und Hydrolysestabilisator.

Die Rezeptur der beiden Deckschichten entsprach der aus Beispiel 12, sie enthielten jedoch zusätzlich 5 Gew.-% MB5, jedoch keinen Hydrolysestabilisator.

Beispiel 14

Beispiel 11 wurde wiederholt mit der einzigen Abweichung, daß die Folie bei entsprechend reduziertem Anteil an PET noch 10 Gew.-% MB1 enthielt. Das Masterbatch wurde zusammen mit den anderen Rohstoffkomponenten wie in Beispiel 1 beschrieben vorgetrocknet.

Beispiel 15

Beispiel 12 wurde wiederholt mit der einzigen Abweichung, daß die Kernschicht nunmehr zusätzlich 10 Gew.-% MB1 enthielt.

Beispiel 16

Analog zu Beispiel 11 wurde eine Monofolie hergestellt, die neben PET 0,2 Gew.-% Siliciumdioxid, 5 Gew.-% MB5 und 10 Gew.-% MB2 enthielt.

Beispiel 17

Beispiel 12 wurde wiederholt mit der Abweichung, daß die Kernschicht 10 Gew.-% MB2 und 5 Gew.-% MB5 enthielt.

Vergleichsbeispiel 2

Beispiel 11 wurde wiederholt, jedoch auf die Zugabe eines Hydrolysestabilisators verzichtet. Die Monofolie enthielt demnach neben PET 0,2 Gew.-% Silciumdioxid sowie 10 Gew.-% MB5.

Vergleichsbeispiel 3

Beispiel 3 aus GB-A 2 344 596 wurde nachgearbeitet (75 μm Folie mit Flammschutzmittel und UV-Stabilisator).

Beispiel 18

Beispiel 2 wurde wiederholt mit der Abweichung, daß die Folie nunmehr 3 Gew-% MB5 enthielt.

Beispiel 19

Die Folie aus Beispiel 18 wurde in einem Wärmeofen weitestgehend zuglos bei einer Temperatur von 200°C und einer Verweildauer von 60 Sekunden nachbehandelt.

Beispiel 20

Die Folie aus Beispiel 18 wurde mit Trichloressigsäure beidseitig chemisch nachbehandelt, was zu einer reaktiven Oberfläche führte.

Beispiel 21

Die Folie aus Beispiel 2 wurde nach der Längsstreckung mit Hilfe eines "Reverse gravure-roll coating"-Verfahren mit einer wäßrigen Dispersion beidseitig beschichtet. Die Dispersion enthielt neben Wasser

| | |
|---|---|
| 4,20 % | hydrophilischen Polyester (5-Na-sulfoisophthalsäurehaltiges PET/-IPA-Polyester, SP41, Ticona, USA), |
| 0,15 % | kolloidales Siliciumdioxid (®Nalco 1060, Deutsche Nalco Chemie, Deutschland) als Antiblockmittel sowie |
| 0,15 % | Ammoniumcarbonat (Merck, Deutschland) als pH-Puffer. |

Das Naßantragsgewicht betrug 2 g/$m^2$ pro beschichtete Seite. Nach der Querverstreckung lag die berechnete Dicke der Beschichtung bei 40 nm.

Beispiel 22

Es wurde eine hydrolysestabile ABA-Folie mit folgender Rezeptur hergestellt:

| | |
|---|---|
| Basisschicht (72 µm dick): | 50 Gew.-% PET 4020, 10 Gew.-% MB2, 5 Gew.-% MB3 und 35 Gew.-% immanent angefallenes Regenerat. |
| Deckschichten A (je 1,5 µm): | 93 Gew.-% PET 4020 und 7 Gew.-% MB4. |

Beispiel 23

Analog Beispiel 22 wurde eine hydrolyse- und UV-stabile A-B-A-Folie mit folgender Rezeptur hergestellt:

| | |
|---|---|
| Basisschicht (72 µm dick): | 50 Gew.-% PET 4020, 5 Gew.-% MB2, 3 Gew.-% MB3 und 35 Gew.% immanent angefallenes Regenerat. |
| Deckschichten A (je 1,5 µm): | 78 Gew.-% 4020, 7 Gew.% MB4, 10 Gew.-% MB1 sowie 5 Gew.-% MB3. |

Beispiel 24

Durch Coextrusion wurde eine 12 µm dicke siegelfähige A-B-C-Folie mit einer 10 µm dicken Basisschicht B aus 50 Gew.-% PET 4020, 10 Gew.-% MB2 sowie 40 Gew.-% immanent angefallenem Regenerat hergestellt.

Für die 1 µm dicke siegelfähige Deckschicht A wurde als Thermoplast ein Copolyester aus 78 mol-% Ethylenterephthalat und 22 mol-% Ethylenisophthalat verwendet (hergestellt durch Umesterung in Gegenwart eines Mangankatalysators, Mn-Konzentration: 100 ppm). Sie enthielt weiterhin 3,0 % des Masterbatches MB4 als Antiblockmittel.

Die 1 µm dicke Deckschicht C enthielt neben 93,0 Gew.-% PET 4020 7,0 Gew.-% des Masterbatches MB4.

Beispiel 25

Wie im Beispiel 24 beschrieben wurde eine 12 µm dicke, hydrolysestabile, transparente, coextrudierte, siegelfähige A-B-C-Folie hergestellt. Im Unterschied zu Beispiel 24 wurde die nicht siegelfähige Deckschicht C nach der Längsstreckung durch "Reverse gravure-roll coating" mit einer wäßrigen Dispersion einseitig beschichtet. Die Dispersion hatte die gleiche Zusammensetzung wie im Beispiel 21. Das Naßantragsgewicht betrug 2 g/$m^2$. Nach der Querstreckung lag die berechnete Dicke der Beschichtung bei 40 nm.

Beispiel 26

Wie in Beispiel 2 beschrieben, wurde ein Folie hergestellt, die zusätzlich 7,5 Gew.-% MB6 enthielt. Sie wurde einseitig coronabehandelt. Die Intensität wurde so gewählt, daß die Oberflächenspannung der Folie nach der Behandlung bei mehr als 45 mN/m lag.

Die Eigenschaften der erfindungsgemäßen Folien sind den nachfolgenden Tabellen zu entnehmen.

Tabelle 1 (nicht funktionalisierte Folien)

| Eigenschaften | | | B1 | B2 | B3 | B4 | B5 | B6 | B7 | B8 | B9 | 810 | VB1 |
|---|---|---|---|---|---|---|---|---|---|---|---|---|---|
| Hydrolysestabilisatoren | | Anzahl | 1 | 1 | 1 | 1 | 2 | 1 | 2 | 1 | 1 | 2 | 0 |
| Schichten | | Anzahl* | 1 | 1 | 1 | 1 | 1 | 1 | 1 | 3 | 3 | 3 | 1 |
| Glanz | | außen | 155 | 156 | 151 | 100 | 160 | 157 | 153 | 185 | 170 | 176 | 150 |
| | | innen | 160 | 160 | 160 | 100 | 165 | 161 | 156 | 185 | 175 | 178 | 155 |
| Lichttransmission/ Transparenz | | % | 89 | 86 | 87 | 73 | 89 | 92 | 82 | 94 | 91 | 91 | 89 |
| Trübung | | % | 14 | 16 | 17 | 25 | 13 | 12 | 21 | 2 | 2,5 | 3,5 | 13 |
| Gelbwert (YID) | | | 2,4 | 2,6 | 2,5 | 2,5 | 2,3 | 1,4 | 2,9 | 1,8 | 2,0 | 2,1 | 1,7 |
| Elastizitätsmodul | längs | $N/mm^2$ | 4000 | 4000 | 4100 | 4100 | 4100 | 4050 | 4200 | 4100 | 4100 | 4000 | 4050 |
| | quer | $N/mm^2$ | 5200 | 5100 | 5150 | 5100 | 5200 | 5200 | 5250 | 5250 | 5300 | 5100 | 5200 |
| Schrumpf | längs | % | 1,3 | 1,3 | 0,6 | 1,3 | 1,2 | 1,2 | 1,4 | 1,0 | 1,2 | 0,9 | 1,4 |
| | quer | % | 0,6 | 0,7 | 0,2 | 0,7 | 0,8 | 0,7 | 1,0 | 0,4 | 0,6 | 0,4 | 0,5 |

*Hier und in den folgenden Tabellen bezieht sich der Begriff "Anzahl" auf die durch Extrusion bzw.Coextrusion erhaltenen Schichten, d.h. ohne Berücksichtigung nachträglich aufgebrachter Beschichtungen

Tabelle 1. Fortsetzung

| Eigenschaften | | | B1 | B2 | B3 | B4 | B5 | B6 | B7 | B8 | B9 | B10 | VB1 |
|---|---|---|---|---|---|---|---|---|---|---|---|---|---|
| **Reißfestigkeit** | längs | N/mm$^2$ | 170 | 170 | 180 | 165 | 175 | 170 | 180 | 170 | 170 | 175 | 175 |
| | quer | N/mm$^2$ | 280 | 270 | 275 | 270 | 275 | 270 | 270 | 285 | 285 | 275 | 275 |
| dto. nach 1000h bei 130°C | längs | | ja | ja | ja | ja | ja | ja | ja | ja | ja | ja | nein |
| | quer | | ja | ja | ja | ja | ja | ja | ja | ja | ja | ja | nein |
| dto. nach 1.000 h bei 85 °C, 95% rel. Luftfeuchte | längs | | ja | ja | ja | ja | ja | ja | ja | ja | ja | ja | nein |
| | quer | | ja | ja | ja | ja | ja | ja | ja | ja | ja | ja | nein |
| **Reißdehnung** | längs | % | 170 | 170 | 170 | 170 | 165 | 168 | 170 | 165 | 160 | 163 | 170 |
| | quer | % | 90 | 90 | 90 | 93 | 95 | 101 | 100 | 95 | 90 | 92 | 95 |
| **Reaktive Oberfläche** | | | | | | + | | | | | | | |

ja = Prüfung auf Hochtemperaturbeständigkeit bzw. Klimatest bestanden, nein = nicht bestanden

Tabelle 2 (mit Flammschutzmittel funktionalisierte Folien)

| Eigenschaften | | | B11 | B12 | B13 | B14 | B15 | B16 | B17 | B18 | B19 | B20 | VB2 | VB3 |
|---|---|---|---|---|---|---|---|---|---|---|---|---|---|---|
| Hydrolysestabilisatoren | | Anzahl | 1 | 1 | 1 | 2 | 2 | 1 | 1 | 1 | 1 | 1 | 0 | 0 |
| Schichten | | Anzahl | 1 | 3 | 3 | 1 | 3 | 1 | 3 | 1 | 1 | 1 | 1 | 1 |
| Glanz | | außen | 160 | 175 | 170 | 150 | 165 | 165 | 170 | 154 | 154 | 115 | 160 | 150 |
| | | innen | 160 | 180 | 165 | 155 | 158 | 170 | 165 | 158 | 158 | 110 | 155 | 155 |
| Lichttransmissionl Transparenz | | % | 90 | 91 | 90 | 89 | 88 | 88 | 90 | 88 | 88 | 70 | 89 | 90 |
| Trübung | | % | 14 | 3 | 3,2 | 15 | 3,2 | 14 | 3 | 15 | 15 | 28 | 14 | 13 |
| Gelbwert (YID) | | | 2,4 | 2,4 | 2,5 | 2,6 | 2,7 | 2,3 | 2,1 | 2,3 | 2,3 | 2,0 | 2,1 | 2,0 |
| Elastizitätsmodul | längs | $N/mm^2$ | 4000 | 4100 | 4000 | 4100 | 3900 | 4000 | 4100 | 4000 | 4000 | 4000 | 3800 | 4050 |
| | quer | $N/mm^2$ | 5200 | 5200 | 5000 | 5050 | 5000 | 5100 | 5200 | 5100 | 5100 | 5100 | 4800 | 5050 |
| Schrumpf | längs | % | 1,1 | 1,2 | 1,2 | 1,3 | 1,4 | 1,1 | 1,1 | 1,4 | 0,3 | 1,4 | 1,4 | 1,3 |
| | quer | % | 0,5 | 0,6 | 0,5 | 0,6 | 0,5 | 0,6 | 0,5 | 0,6 | 0,1 | 0,6 | 0,5 | 0,8 |

**Tabellen 2. Fortsetzung**

| Eigenschaften | | | **B11** | **B12** | **B13** | **B14** | **B15** | **B16** | **B17** | **B18** | **B19** | **B20** | **VB2** | **VB3** |
|---|---|---|---|---|---|---|---|---|---|---|---|---|---|---|
| **Reißfestigkeit** | längs | $N/mm^2$ | 170 | 175 | 165 | 170 | 170 | 175 | 165 | 170 | 170 | 175 | 162 | 170 |
| | quer | $N/mm^2$ | 280 | 275 | 270 | 285 | 185 | 270 | 270 | 270 | 270 | 275 | 250 | 255 |
| dto. nach 1000h bei 130 °C | längs | | ja | ja | ja | ja | ja | ja | ja | ja | ja | ja | nein | nein |
| | quer | | ja | ja | ja | ja | ja | ja | ja | ja | ja | ja | nein | nein |
| dto. nach 1.000 h bei 85 °C, 95% rel. Luftfeuchte | längs | | ja | ja | ja | ja | ja | ja | ja | ja | ja | ja | nein | nein |
| | quer | | ja | ja | ja | ja | ja | ja | ja | ja | ja | ja | nein | nein |
| **Reißdehnung** | längs | % | 170 | 165 | 170 | 165 | 160 | 165 | 170 | 170 | 170 | 170 | 145 | 155 |
| | quer | % | 90 | 100 | 100 | 95 | 90 | 95 | 100 | 90 | 90 | 90 | 85 | 95 |
| **Flammstabilität** | | | ++ | ++ | ++ | ++ | ++ | ++ | ++ | ++ | ++ | ++ | ++ | ++ |
| ++ erfüllt Brandklassen B1, B2 und UL-Test 94 | | | | | | | | | | | | | | |

Tabelle 3 (weitere Funktionalisierungen)

| Eigenschaften | | | B21 | B22 | B23 | B24 | B25 | B26 |
|---|---|---|---|---|---|---|---|---|
| **Dicke** | | | 75 | 75 | 75 | 12 | 12 | 75 |
| **Hydrolysestabilisatoren** | | Anzahl | 1 | 1 | 2 | 1 | 1 | 1 |
| **Schichten** | | Anzahl | 1 | 3 | 3 | 3 | 3 | 1 |
| **Glanz** | | außen | 162 | 185 | 180 | 196 | 198 | 150 |
| | | innen | 168 | 185 | 180 | 200 | 202 | 158 |
| **Lichttransmission Transparenz** | | % | 87 | 94 | 88 | 95 | 91,4 | 83 |
| **Trübung** | | % | 16 | 2,7 | 3,5 | 2,0 | 2,0 | 18 |
| **Gelbwert (YID)** | | | 2,3 | 1,8 | 2,5 | 1,3 | 1,4 | - |
| **Elastizitätsmodul** | längs | N/mm2 | 4000 | 4100 | 4100 | 4200 | 4200 | 4100 |
| | quer | N/mm2 | 5100 | 5150 | 5100 | 5000 | 5000 | 5150 |
| **Schrumpf** | längs | % | 1,3 | 1,0 | 1,2 | 1,2 | 1,2 | 1,3 |
| | quer | % | 0,6 | 0,3 | 0,4 | 0,3 | 0,3 | 0,6 |
| **Reißfestigkeit** | längs | % | 175 | 170 | 165 | 255 | 250 | 175 |
| | quer % | | 275 | 270 270 | | 250 | 250 | 270 |
| **UV-Stabilität/Absorption** | | nm | <380 | <290 | <290 | <380 | <380 | <380 |
| **Beschichtung/Haftung** | | | ++ | | | | ++ | |
| **Mindestsiegeltemperatur A/A** | | °C | | | | 95 | 96 | |
| **Siegelnahtfestigkeit A/A** | | N/mm2 | | | | 2,3 | 2,4 | |
| Einfärbung | | | | | | | | blau |
| **Oberflächenspannung** | | mN/m | 40 | 40 | 40 | 40 | 40 | 48 |
| **Kilmatest** | | | ja | ja | ja | ja | ja | ja |
| **Hochtemperatur-beständigkeit** | | | ja | ja | ja | ja | ja | ja |
| ++ = verbesserte Haftvermittlung ja = Test bestanden | | | | | | | | |

**Patentansprüche**

**1.** Ein- oder mehrschichtige, transparente, biaxial orientierte und thermofixierte Folie mit einer Dicke von 1 bis 500 µm, die als Hauptbestandteil mindestens einen kristallisierbaren Polyester oder Copolyester enthält, ausgewählt aus Polyethylenterephthalat, Polybutylenterephthalat, bibenzolmodifiziertes Polyethylenterephthalat und bibenzolmodifiziertes Polybutylenterephthalat, **dadurch gekennzeichnet, daß** sie mindestens einen Hydrolysestabilisator enthält, wobei der Hydrolysestabilisator ein monomeres oder polymeres Carbodiimid und/oder ein Oxazolin umfaßt und der Anteil des monomeren oder polymeren Carbodiimids und/oder des Oxazolins 0,1 bis 5,0 Gew.-% beträgt, bezogen auf das Gewicht der einschichtigen Folie bzw. der damit ausgerüsteten Schicht der mehrschichtigen Folie.

**2.** Folie gemäß Anspruch 1, **dadurch gekennzeichnet, daß** der Polyester oder Copolyester Polyethylenterephthalat oder bibenzolmodifiziertes Polyethylenterephthalat ist.

**3.** Folie gemäß Anspruch 1 oder 2, **dadurch gekennzeichnet, daß** der Hydrolysestabilisator eine phenolische Verbindung umfaßt, bevorzugt ein sterisch gehindertes Phenol, Thio-bisphenol, Alkyliden-bisphenol, Alkylphenol, eine Hydroxybenzylverbindung, ein Acyl-amino-phenol und/oder ein Hydroxyphenylpropionat ist.

**4.** Folie gemäß Anspruch 3, **dadurch gekennzeichnet, daß** der Anteil der phenolischen Verbindung 0,1 bis 8,0 Gew.-%, bevorzugt 0,2 bis 5,0 Gew.-%, beträgt, jeweils bezogen auf das Gewicht der Folie bzw. der damit ausgerüsteten

Schicht der mehrschichtigen Folie.

5. Folie gemäß Anspruch 3 oder 4, **dadurch gekennzeichnet, daß** die phenolische Verbindung kombiniert ist mit mindestens einem organischen Phosphit, insbesondere mit einem Triarylphosphit, wobei das Gewichtsverhältnis der phenolischen Verbindung zu dem organischen Phosphit vorzugsweise 10 : 90 bis 90 : 10 beträgt.

6. Folie gemäß Anspruch 1, **dadurch gekennzeichnet, daß** das polymere Carbodiimid ein Molekulargewicht von 2.000 bis 50.000 besitzt.

7. Folie gemäß Anspruch 6 1, **dadurch gekennzeichnet, daß** der Anteil des monomeren oder polymeren Carbodiimids und/oder des Oxazolins 0,2 bis 3,0 Gew.-% beträgt, jeweils bezogen auf das Gewicht der einschichtigen Folie bzw. der damit ausgerüsteten Schicht der mehrschichtigen Folie.

8. Folie gemäß Anspruch 1, **dadurch gekennzeichnet, daß** der Hydrolysestabilisator ein Gemisch aus 0,1 bis 5 Gew.-% an polymeren aromatischen Carbodiimiden und 0,1 bis 5 Gew.-% eines Blends aus 30 bis 90 Gew.-% eines organischen Phosphits und 70 bis 10 Gew.-% eines Hydroxyphenylpropionats ist.

9. Folie gemäß Anspruch einem oder mehreren der Ansprüche 1 bis 8, **dadurch gekennzeichnet, daß** der Anteil aller Hydrolysestabilisatoren zusammen 0,2 bis 16,0 Gew.-%, bevorzugt 0,5 bis 14,0 Gew.-%, jeweils bezogen auf das Gewicht der Folie bzw. der betreffenden Schicht der mehrschichtigen Folie, beträgt.

10. Folie gemäß einem oder mehreren der Ansprüche 1 bis 9, **dadurch gekennzeichnet, daß** ihre Gesamtdicke 5 bis 350 $\mu$m, bevorzugt 10 bis 300 $\mu$m, beträgt.

11. Folie gemäß einem oder mehreren der Ansprüche 1 bis 10, **dadurch gekennzeichnet, daß** sie einen UV-Stabilisator enthält, flammhemmend ausgerüstet, auf einer Seite oder auf beiden Seiten beschichtet, siegelfähig und/oder corona- bzw. flammbehandelt ist.

12. Folie gemäß Anspruch 11, **dadurch gekennzeichnet, daß** der Anteil des UV-Stabilisators 0,1 bis 5,0 Gew.-%, bevorzugt 0,5 bis 3,0 Gew.-%, beträgt, jeweils bezogen auf das Gesamtgewicht der mindestens einen Schicht, und vorzugsweise 2-(4,6-Diphenyl-[1,3,5]triazin-2-yl)-5-hexyloxy-phenol, 2,2'-Methylen-bis-[6-benzotriazol-2-yl-4-(1,1,2,2-tetramethyl-propyl)-phenol] oder 2,2'-(1,4-Phenylen)-bis-[[3,1]benzoxazin-4-on] ist.

13. Folie gemäß Anspruch 11, **dadurch gekennzeichnet, daß** der Anteil des Flammschutzmittels 0,5 bis 30,0 Gew.-%, bevorzugt 1,0 bis 20,0 Gew.-%, beträgt, bezogen auf das Gewicht der Schicht des kristallisierbaren Polyesters oder Copolyesters.

14. Folie gemäß einem oder mehreren der Ansprüche 11 bis 13, **dadurch gekennzeichnet, daß** sie zusätzlich eine siegelfähige Deckschicht umfaßt.

15. Folie gemäß einem oder mehreren der Ansprüche 1 bis 14, **dadurch gekennzeichnet, daß** sie nach 15 minütigem Erhitzen auf 150 °C gemäß DIN 40634 einen Schrumpf in Längs- und Querrichtung von jeweils weniger als 1,5 %, bevorzugt weniger als 1,3 %, besonders bevorzugt weniger als 1,1 %, aufweist.

16. Folie gemäß einem oder mehreren der Ansprüche 1 bis 15, **dadurch gekennzeichnet, daß** sie rezyclierbar ist.

17. Verfahren zur Herstellung der Folie gemäß einem oder mehreren der Ansprüche 1 bis 16, **dadurch gekennzeichnet, daß** ein Gemisch, das mindestens einen kristallisierbaren Polyester oder Copolyester als Hauptbestandteil und mindestens einen Hydrolysestabilisator umfaßt, in einem Extruder aufgeschmolzen und durch Extrusion oder Coextrusion zu einer weitgehend amorphen ein- oder mehrschichtigen Vorfolie geformt wird, die gebildete Folie auf einer Kühlwalze abgeschreckt, anschließend erneut erhitzt, in Längs- und/oder Querrichtung verstreckt und schließlich thermofixiert wird.

18. Verfahren nach Anspruch 17, **dadurch gekennzeichnet, dass** der mindestens eine Hydrolysestabilisator in Form eines vorkristallisierten oder vorgetrockneten Masterbatches vor der Extrusion oder Coextrusion zugegeben wird

19. Verwendung der Folie gemäß einem oder mehreren der Ansprüche 1 bis 16 im Innen- und Außenbereich, auf dem Bausektor und im Messebau, im Laden- und Regalbau, im Elektronikbereich und auf dem Beleuchtungssektor, für

Gewächshäuser, Innenraumverkleidungen, Messe- und Werbeartikel, Lichtwerbeprofile, flexible Leiter in der Automobilindustrie, Schutzverglasungen von Maschinen und Fahrzeugen, Flachkabel, flexible, gedruckte Schaltungen, Kondensatoren, Displays, Schilder, Kaschiermedien, Schattenmatten, Elektroanwendungen.

## Claims

1. A transparent, biaxially oriented and heat-set film having one or more layers and having a thickness of 1 to 500 μm, and comprising, as main constituent, at least one crystallizable polyester or copolyester, selected from polyethylene terephthalate, polybutylene terephthalate, bibenzoyl-modified polyethylene terephthalate and bibenzoyl-modified polybutylene terephthalate, wherein the film comprises at least one hydrolysis stabilizer, where the hydrolysis stabilizer encompasses a monomeric or polymeric carbodiimide and/or an oxazoline and the proportion of the monomeric or polymeric carbodiimide and/or of the oxazoline is from 0.1 to 5.0 % by weight, based on the weight of the single-layer film or of the layer modified therewith in the multilayer film.

2. The film as claimed in claim 1, wherein the polyester or copolyester is polyethylene terephthalate or bibenzoyl-modified polyethylene terephthalate.

3. The film as claimed in claim 1 or 2, wherein the hydrolysis stabilizer encompasses a phenolic compound, preferably a sterically hindered phenol, thiobisphenol, alkylidenebisphenol, or alkylphenol, or a hydroxybenzyl compound, or an acylaminophenol and/or a hydroxyphenyl propionate.

4. The film as claimed in claim 3, wherein the proportion of the phenolic compound is from 0.1 to 8.0 % by weight, preferably from 0.2 to 5.0 % by weight, based in each case on the weight of the film or, respectively, of the layer provided therewith within the film having more than one layer.

5. The film as claimed in claim 3 or 4, wherein the phenolic compound has been combined with at least one organic phosphite, in particular with a triaryl phosphite, the ratio by weight of the phenolic compound to the organic phosphite preferably being from 10 : 90 to 90 : 10.

6. The film as claimed in claim 1, wherein the polymeric carbodiimide has a molecular weight of from 2000 to 50 000.

7. The film as claimed in claim 1, wherein the proportion of the monomeric or polymeric carbodiimide, and/or of the oxazoline, is from 0.2 to 3.0 % by weight, based in each case on the weight of the single-layer film or, respectively, of the layer provided therewith within the film having more than one layer.

8. The film as claimed in claim 1, wherein the hydrolysis stabilizer is a mixture made from 0.1 to 5 % by weight of polymeric aromatic carbodiimides and 0.1 to 5 % by weight of a blend made from 30 to 90 % by weight of an organic phosphite and 70 to 10 % by weight of a hydroxyphenyl propionate.

9. The film as claimed in one or more of claims 1 to 8, wherein the proportion of all of the hydrolysis stabilizers together is from 0.2 to 16.0 %, preferably from 0.5 to 14.0 % by weight, based in each case on the weight of the film or, respectively, of the relevant layer within the film having more than one layer.

10. The film as claimed in one or more of claims 1 to 9, whose total thickness is from 5 to 350 μm, preferably from 10 to 300 μm.

11. The film as claimed in one or more of claims 1 to 10, which comprises a UV-stabilizer, or has been modified so as to be flame-retardant, or on one side or on both sides has been coated, or is sealable, and/or has been corona- or flame-treated.

12. The film as claimed in claim 11, wherein the content of the UV stabilizer is from 0.1 to 5.0 % by weight, preferably from 0.5 to 3.0 % by weight, based in each case on the total weight of the at least one layer, and is preferably 2-(4,6-diphenyl-[1,3,5]-triazin-2-yl)-5-hexyloxyphenol, 2,2'-methylenebis[6-benzotriazol-2-yl-4-(1,1,2,2-tetramethylpropyl) phenol] or 2,2'-(1,4-phenylene)bis[[3,1]benzoxazin-4-one].

13. The film as claimed in claim 11, wherein the proportion of the flame retardant is from 0.5 to 30.0 % by weight, preferably from 1.0 to 20.0 % by weight, based on the weight of the layer of the crystallizable polyester or copolyester.

**14.** The film as claimed in one or more of claims 11 to 13, which additionally encompasses a sealable outer layer.

**15.** The film as claimed in one or more of claims 1 to 14, wherein the longitudinal and transverse shrinkage according to DIN 40634 of the film after 15 minutes of heating to 150 °C are each less than 1.5 %, preferably less than 1.3 %, particularly preferably less than 1.1%.

**16.** The film as claimed in one or more of claims 1 to 15, which can be recycled.

**17.** A process for producing the film as claimed in one or more of claims 1 to 16, wherein a mixture which encompasses at least one crystallizable polyester or copolyester as main constituent and encompasses at least one hydrolysis stabilizer is melted in an extruder and shaped by extrusion or coextrusion to give a substantialy amorphous prefilm having one or more layers, the film formed is quenched on a chill roll, then reheated, oriented longitudinally and/or transversely, and finally heat-set.

**18.** The process as claimed in claim 17, wherein the at least one hydrolysis stabilizer is added, prior to extrusion or coextrusion, in the form of a precrystallized or predried masterbatch.

**19.** The use of the film as claimed in one or more of claims 1 to 16 in the indoor or outdoor sector, in the construction sector, or in the construction of exhibition stands, in the fitting out of shops or of stores, in the electronics sector, or in the lighting sector, for greenhouses, interior decoration, exhibition requisites, promotional requisites, illuminated advertising profiles, flexible conductors in the automotive industry, protective glazing for machines or for vehicles, flat cables, flexible printed circuits, capacitors, displays, placards, laminating media, blinds, or electrical applications.

## Revendications

**1.** Film mono- ou multicouche transparent, orienté biaxialement et thermofixé, ayant une épaisseur de 1 à 500 μm, qui contient comme composant principal au moins un polyester ou copolyester cristallisable choisi parmi le poly (éthylène-téréphtalate), le poly(butylène-téréphtalate), le poly(éthylène-téréphtalate) modifié par du bibenzène, et le poly(butylène-téréphtalate) modifié par du bibenzène, **caractérisé en ce qu'**il contient au moins un stabilisant vis-à-vis de l'hydrolyse, ce stabilisant vis-à-vis de l'hydrolyse comprenant un carbodiimide monomère ou polymère et/ou une oxazoline et la teneur en carbodiimide monomère ou polymère et/ou oxazoline allant de 0,1 à 5,0 % en poids, par rapport au poids du film monocouche ou bien par rapport au poids de la couche du film multicouche munie de ces composés.

**2.** Film selon la revendication 1, **caractérisé en ce que** le polyester ou copolyester est du poly(éthylène-téréphtalate) ou du poly(éthylène-téréphtalate) modifié par du bibenzène.

**3.** Film selon la revendication 1 ou 2, **caractérisé en ce que** le stabilisant vis-à-vis de l'hydrolyse comprend un composé phénolique, de préférence un alkylphénol, alkylidène-bisphénol, thio-bisphénol, phénol encombré stériquement, un composé hydroxybenzylique, un acylaminophénol et/ou un propionate d'hydroxyphényle.

**4.** Film selon la revendication 3, **caractérisé en ce que** la teneur en composé phénolique va de 0,1 à 8,0 % en poids, de préférence de 0,2 à 5,0 % en poids, chaque fois par rapport au poids du film ou de la couche du film multicouche munie de ce composé.

**5.** Film selon la revendication 3 ou 4, **caractérisé en ce que** le composé phénolique est associé à au moins un phosphite organique, en particulier à un phosphite de triaryle, le rapport pondéral du composé phénolique au phosphite organique allant de préférence de 10:90 à 90:10.

**6.** Film selon la revendication 1, **caractérisé en ce que** le polymère carbodiimide a une masse moléculaire de 2 000 à 50 000.

**7.** Film selon la revendication 1, **caractérisé en ce que** la teneur en carbodiimide monomère ou polymère et/ou oxazoline va de 0,2 à 3,0 % en poids, chaque fois par rapport au poids du film monocouche ou de la couche du film multicouche munie de ces composés..

**8.** Film selon la revendication 1, **caractérisé en ce que** le stabilisant vis-à-vis de l'hydrolyse est un mélange de 0,1

à 5 % en poids de carbodiimides aromatiques polymères et de 0,1 à 5 % en poids d'un mélange de 30 à 90 % en poids d'un phosphite organique et de 70 à 10 % en poids d'un propionate d'hydroxyphényle.

9. Film selon une ou plusieurs des revendications 1 à 8, **caractérisé en ce que** la teneur de l'ensemble de tous les stabilisants vis-à-vis de l'hydrolyse va de 0,2 à 16,0 % en poids, de préférence de 0,5 à 14,0 % en poids, chaque fois par rapport au poids du film ou de la couche concernée du film multicouche.

10. Film selon une ou plusieurs des revendications 1 à 9, **caractérisé en ce que** son épaisseur totale va de 5 à 350 μm, de préférence de 10 à 300 μm.

11. Film selon une ou plusieurs des revendications 1 à 10, **caractérisé en ce qu'**il contient un stabilisant UV, est muni d'un agent ignifuge, est revêtu sur une face ou sur les deux, est soudable et/ou traité à la flamme et/ou par corona.

12. Film selon la revendication 11, **caractérisé en ce que** la teneur en stabilisant UV va de 0,1 à 5,0 % en poids, de préférence de 0,5 à 3,0 % en poids, chaque fois par rapport au poids total de ladite au moins une couche et le stabilisant UV est de préférence le 2-(4,6-diphényl-[1,3,5]triazin-2-yl)-5-hydroxyphénol, le 2,2'-méthylène-bis[6-benzotriazol-2-yl-4-(1,1,2,2-tétraméthyl-propyl)phénol] ou la 2,2'-(1,4-phénylène-bis[[3,1]benzoxazin-4-one].

13. Film selon la revendication 11, **caractérisé en ce que** la teneur en l'agent ignifuge va de 0,5 à 30,0 % en poids, de préférence de 1,0 à 20,0 % en poids, par rapport au poids de la couche du polyester ou copolyester cristallisable.

14. Film selon une ou plusieurs des revendications 11 à 13, **caractérisé en ce qu'**il comprend en outre une couche de recouvrement soudable.

15. Film selon une ou plusieurs des revendications 1 à 14, **caractérisé en ce qu'**il présente après un chauffage de 15 minutes à 150 °C selon DIN 40634 un retrait dans le sens longitudinal et le sens transversal respectivement de moins de 1,5 %, de préférence de moins de 1,3 %, de façon particulièrement préférée de moins de 1,1 %.

16. Film selon une ou plusieurs des revendications 1 à 15, **caractérisé en ce qu'**il est recyclable.

17. Procédé pour la fabrication du film selon une ou plusieurs des revendications 1 à 16, **caractérisé en ce qu'**un mélange qui comprend au moins un polyester ou copolyester cristallisable en tant que composant principal et au moins un stabilisant vis-à-vis de l'hydrolyse est fondu dans une extrudeuse et est mis en forme par extrusion ou coextrusion sous forme d'un préfilm mono- ou multicouche essentiellement amorphe, le film formé étant refroidi brusquement sur un cylindre refroidisseur, puis de nouveau chauffé, étiré dans le sens longitudinal et/ou dans le sens transversal, et enfin thermofixé.

18. Procédé selon la revendication 17, **caractérisé en ce que** ledit au moins un stabilisant vis-à-vis de l'hydrolyse est ajouté sous forme d'un mélange-maître précristallisé ou préséché, avant l'extrusion ou la coextrusion.

19. Utilisation du film selon une ou plusieurs des revendications 1 à 16, dans le secteur intérieur et extérieur, dans le domaine du bâtiment et dans le montage d'expositions, dans l'installation de magasins et de rayonnages, dans le domaine de l'électronique et dans le secteur de l'éclairage, pour des serres, des habillages intérieurs, des articles publicitaires et d'exposition, des profilés pour publicité lumineuse, des guides flexibles dans l'industrie de l'automobile, des câbles plats, des circuits imprimés flexibles, des condensateurs, des afficheurs, des panneaux, des milieux de contre-collage, des mats d'ombrage, des applications électriques.